(19) **Europäisches Patentamt**
**European Patent Office**
**Office européen des brevets**

(11) **EP 4 749 305 A1**

(12) **EUROPEAN PATENT APPLICATION**

(43) Date of publication:
**27.05.2026 Bulletin 2026/22**

(21) Application number: **24215596.8**

(22) Date of filing: **26.11.2024**

(51) International Patent Classification (IPC):
**G01R 31/382** (2019.01)　　**G01R 31/392** (2019.01)
**H01M 10/48** (2006.01)　　**G01R 33/032** (2006.01)

(52) Cooperative Patent Classification (CPC):
**G01R 31/392; G01R 31/382; G01R 33/0005;**
**G01R 33/007; G01R 33/0094; H01M 10/48;**
G01R 33/032; G01R 33/0354

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **CDO2 Germany UG**
**38126 Braunschweig (DE)**

(72) Inventors:
- **KRUEGER, Peter**
 **38126 Braunschweig (DE)**
- **KENDALL, Gary**
 **38126 Braunschweig (DE)**

(74) Representative: **Dehns**
 **10 Old Bailey**
 **London EC4M 7NG (GB)**

(54) **METHOD OF CHARACTERISING A BATTERY**

(57)　　A method of characterising a condition of an electrochemical cell 100 comprising a plurality of electrodes, the method comprising: positioning one or more magnetometers 200 adjacent to an electrode surface of the electrochemical cell to measure magnetic field of the electrochemical cell at a first location 202; measuring the magnetic field generated by the electrochemical cell for a predetermined length of time, the measuring providing a first temporal profile of the magnetic field in an x-direction and a second temporal profile of the magnetic field in a y-direction, at the first location; confirming occurrence of a transient current inhomogeneity within the electrochemical cell based on identifying a step-change in an x-component of the magnetic field from the first temporal profile and a coincident step-change in a y-component of the magnetic field from the second temporal profile; and determining a characteristic of the electrochemical cell based on the occurrence of transient current inhomogeneities.

Figure 1

Processed by Luminess, 75001 PARIS (FR)

**Description**

The present invention relates to a method of characterisation of electrochemical cells. The invention is particularly useful for, but not limited to, the characterisation of lithium-ion electrochemical cells, such as those used in lithium-ion batteries within electric vehicles.

The present invention is also particularly useful when employed in the analysis of electrochemical cell performance within a research and development stage of electrochemical cell and battery production, within mass production of electrochemical cells, and within monitoring of electrochemical cells during their use.

Recently, much attention has been attracted to electricity storage technologies including battery cells such as those in lithium-ion batteries. Lithium-ion cells can produce high voltage (e.g. approximately 3.7 V) and have high energy densities because the battery uses a nonaqueous electrolyte. As a result, the lithium-ion battery is particularly useful in applications such as electric and hybrid vehicles because the lithium-ion battery can produce the high voltages required for the vehicle whilst being relatively lightweight and of a small size.

It is desirable to characterise an electrochemical cell in order to illustrate properties relating to the cell's condition such as the quality, efficiency, lifetime, degradation rate of the cell. The characterisation of a condition of the cell can also be informative of the cell's performance/operation. Characterising an electrochemical cell allows for direct comparison between different compositions or configurations of electrochemical cells.

One issue with lithium-ion cells is that internal structures having a high surface area have a tendency to form on and around the anode. Exemplary high surface area structures include dendrites and mossy structures.

Dendrites and mossy structures are defects that result in a common failure mode within lithium-ion cells. It is understood that dendrites form on the surface of the anode with a needle-like structure. Lithium dendrites can grow through the cell during charging and discharging, resulting in localized internal currents and ultimately resulting in a localized internal short circuit. These may be "soft shorts" that burn out rapidly, resulting in a temporary self-discharge of the cell, or "strong shorts" consisting of a higher, more stable contact area that can lead to complete discharge of the cell, cell failure, and even thermal runaway. Temporary self-discharges caused by soft-shorts can be detected as transient current inhomogeneities within the electrochemical cell, and these will be local to/originate from the defect causing the soft short. It is desirable to identify optimal properties for the electrochemical cell to reduce impact of such defects, e.g. dendrites and mossy structures.

Lithium-ion cells undergo a lithiation process during manufacturing. This conditioning phase creates a solid electrolyte interface (SEI) on the anode. The SEI is electrically insulating but has sufficient ionic conductivity to allow the electrochemical cell to function normally.

While the SEI layer therefore slightly lowers the capacity, it also protects the battery. The SEI layer plays an important role in the prevention of dendrite and mossy structure growth during the lifetime of a cell, which occurs through repeated cycling of the cell. It is therefore desirable to identify optimal properties for the SEI (composition, geometry) in order to reduce the degree to which an electrochemical cell is impacted by dendrites and mossy structures.

Present methods for analysing the impact of dendrites and mossy structures on electrochemical cells involve destructive testing. In such methods, electrodes are removed from the electrochemical cell and analysed using scanning electron microscopy or other suitable observational means. Damaged regions on the electrodes can be identified and attributed to past dendrite formation that occurred while the electrochemical cell was in use.

It is desirable to better understand the impact of dendrites on the functioning of electrochemical cells.

In a first aspect, the present invention provides a method of characterising a condition of an electrochemical cell comprising a plurality of electrodes, the method comprising: positioning one or more magnetometers adjacent to an electrode surface of the electrochemical cell to measure magnetic field of the electrochemical cell at a first location; measuring changes in the magnetic field generated by the electrochemical cell for a predetermined length of time, the measuring providing a first temporal profile of the magnetic field in an x-direction and a second temporal profile of the magnetic field in an y-direction, at the first location; confirming occurrence of a transient current inhomogeneity within the electrochemical cell based on identifying a step-change in an x-component of the magnetic field from the first temporal profile and a coincident step-change in a y-component of the magnetic field from the second temporal profile; and determining a characteristic of the electrochemical cell based on the occurrence of transient current inhomogeneities.

The inventors have been able to study a newly observed mode of degradation of electrochemical cells, which is thought to comprise reversible dendrite formation, while the electrochemical cell is in a passive state. The electrochemical cell is not prevented from functioning as a result of these reversible dendrite formations, however a region of an electrode contacted by the dendrite during its existence can be permanently damaged. This results in a loss of cell capacity corresponding to the damaged area. Hence, the reversible dendrite formation includes a passive degradation mode.

By measuring the magnetic field of the electrochemical cell in a passive state, the occurrence of current inhomogeneities can be identified, which can provide a determination of cell efficiency, state of health and a characterisation of faults within the electrochemical cell. Understanding this mode of degradation can also assist with the design and development of an electrochemical cell. Characterisation of electrochemical cells in this way allows for standards in acceptable electrochemical cell performance to be set. For example, a customer or contractor may have a lower limit on acceptable performance.

This method of characterising a condition of an electrochemical cell is non-invasive and non-destructive. Real-time monitoring of the defects is enabled, allowing further properties of the defects to be studied compared to destructive testing methods. The electrochemical cell can continue to function after the method is performed. This method of characterising a condition of an electrochemical cell allows for degradation within the electrochemical cell to be characterised. A measure of the degradation rate of the cell can be determined. An amount of degradation sustained by the cell so far can be estimated/inferred as a result.

The characteristic of the battery may be indicative of the incidence rate of transient current inhomogeneities and/or may be indicative of the severity of transient current inhomogeneities occurring within the electrochemical cell. The characteristic may provide a rating or certification metric for electrochemical cell quality. Such a rating or certification can be used as safety and ageing tests on electrochemical cells.

By temporal profile it is meant that magnetic field data is linked to time, in particular the time at which it was measured, to create a trace of the magnetic field extending with time. The magnetic field may be measured periodically, e.g., at a frequency of 1 Hz or faster.

The x-direction and the y-direction may be orthogonal directions that are parallel to the electrode surface of the electrochemical cell.

A first magnetometer may measure the magnetic field at the first location in a single direction and a second magnetometer may measure the magnetic field at the first location in another, non-parallel direction. For example, the first magnetometer may measure the magnetic field in a first direction and the second magnetometer may measure the magnetic field in a second direction 90 degrees from the first direction, the measurements obtained from the magnetometers may then be resolved in to the x- and y- components to provide the first and second temporal profiles. In another example, the first magnetometer may measure the magnetic field in the x-direction and the second magnetometer may measure the magnetic field in the y-direction. To simplify the arrangement, a single magnetometer capable of measuring magnetic field in the x- and y- directions may be used. The one or more magnetometers may measure magnetic field in an x-y plane.

The plurality of electrodes may be sheet-like, and so substantially two-dimensional. The plurality of electrodes may comprise a spaced arrangement of electrode layers in which an electrochemically active surface of an anode layer is separated from an electrochemically active surface of an adjacent cathode layer. The spaced arrangement may be a stack of electrode layers in the electrochemical cell, for example, alternating anode layer and cathode layers which are separated from one another by a distance along a normal to the electrode surface so as to have a parallel configuration locally. The plurality of electrodes may comprise a stack of interleaved anode layers and cathode layers.

The anode layers may comprise a plurality of individual anode electrodes and the cathode layers may comprise a plurality of individual cathode electrodes. The anode layers and cathode layers may comprise a single anode and cathode that are rolled, concertinaed, and/or folded in order to create a structure having a plurality of anode and cathode layers.

The electrodes may be planar (i.e. flat) within the electrochemical cell, for example, as a stack of rectangular, planar electrodes (within a pouch cell), or they may be curved or shaped in some other way such that, the electrodes follow a non-Euclidian plane (for example a circular roll or spiral of a cylindrical cell, or, a squashed roll of a prismatic cell etc.). The electrodes may have a parallel configuration locally but the parallel configuration may not remain parallel when viewed non-locally. For example, the plurality of electrodes may be a pair of electrodes wound in a spiral. The plurality of electrodes may be provided in a cylindrical or other configuration.

The electrochemical cell may be in a passive state while measuring the magnetic field generated by the electrochemical cell for the predetermined length of time.

By passive state it is meant that the electrochemical cell is not connected to a load, and is not charging or discharging through an external circuit. The electrochemical cell is in an open circuit configuration, in the sense of being disconnected from a conductive electrical circuit. Thus, no current flows into or out of either terminal of the cell while the cell is in the passive state. The passive state may also include instances in which suitably high loads are applied between the terminals of an electrochemical cell such that the current flow between the terminals is on the order of leakage currents that are experienced in the open circuit configuration.

A charge and/or discharge of the cell may be induced prior to measuring the magnetic field generated by the electrochemical cell for the predetermined length of time. The measuring of the magnetic field generated by the electrochemical cell for the predetermined length of time may take place while the electrochemical cell is in a passive state and may therefore detect the magnetic field of the cell as charge relaxation occurs.

Charge relaxation occurs because the equilibrium charge distribution reached during (dis)charging transitions to a new equilibrium once in open-circuit (passive) configuration. Largely, this can be described as movement of charge carriers from a heterogeneous distribution around the terminals of the cell to a homogeneous distribution throughout the cell.

The charge and/or discharge may be over 5% of the capacity of the electrochemical cell. The charge and/or discharge may be over 10%, or over 30%, of the capacity of the electrochemical cell.

The first location may not necessarily a single point but may be a region in which one or more magnetometers can be positioned to obtain measurements of the magnetic field representative of the field at a single point.

A transient current inhomogeneity is an event in which a current flows (internally) across the gap between adjacent electrodes at a localised area within the cell. These are temporary self-discharges caused by material aggregation or crystallisation on an electrode providing a connection between electrodes to act as a charge transfer path. This material build-up may result in the formation of a dendrite or mossy structure. The material may build up and then disperse so that the current flow is transient. The confirming occurrence of a transient current inhomogeneity within the electrochemical cell may comprise attributing the transient current inhomogeneity to a soft short defect, i.e. a transient dendrite defect.

The measured magnetic field may be stable and therefore not change with time absent any transient current inhomogeneities within the electrochemical cell. In practice, the measured magnetic field may gradually and smoothly change with time absent any transient current inhomogeneities within the electrochemical cell (this can be a result of environmental changes, magnetometer drift, or stray fields, for example).

A transient current inhomogeneity can be identified when the change in field departs from the stable profile or smoothly drifting profile. A step-change may be an abrupt change which translates the temporal profile along the field strength axis after which the profile resumes the stable or smoothly drifting form, at least for a period before the transient current inhomogeneity reverses, typically with a similar characteristic step-change back to an expected magnetic field profile (stable or smoothly drifting profile). The change has a high (steep) gradient which is greater than the gradient of the background drift and the high gradient may be sustained so as to cause a detectable change in the measured magnetic field component. The step-change may be defined by a first point where the rate of change of the component of the magnetic field exceeds a first predetermined value, while the change in magnitude (which may be a positive or negative change in the measured component, depending on the local change in direction of the magnetic field) exceeds a second predetermined value. The step-change may also be defined by a second point where the magnetic field returns back to its previous level or expected previous level considering drift of the measured values. The second point may be where the rate of change of the component of the magnetic field exceeds a third predetermined value, while the change in magnitude (which may be a positive or negative change in the measured component, depending on the local change in direction of the magnetic field) exceeds a fourth predetermined value. The first predetermined value and the third predetermined values may be of substantially the same magnitude (one increasing, one decreasing), and the second and fourth predetermined values may be of substantially the same magnitude (one increasing, one decreasing). The characteristic which is determined in the method may be based, for example, on a magnitude of change in magnetic field caused by a transient current inhomogeneity (e.g., a step-height of the step-change, or the step-height as a function of the duration of the transient current inhomogeneity), or a rate of change of magnetic field caused by a transient current inhomogeneity.

The step-change may have a magnitude of more than 3 pT. That is, the change in magnetic field strength may be positive and be a change greater 3 pT, or maybe be negative and be a change greater than 3 pT. The step-change may have a magnitude greater than 5 pT, or greater than 10 pT. The step-change may have a magnitude lower than 100 pT, or lower than 50 pT. The step-change may take place in a time period of less than 500 seconds. The step-change may take place in a time period of less than 300 seconds. The step-change may take place in a time period of less than 100 seconds. The step-change may take place in a time period of more than 10 seconds. Thus, the step change may have a rate of change of magnetic field greater than 6 fTs⁻¹, greater than 16 fTs⁻¹, greater than 33 fTs⁻¹, or greater than 0.1 pTs⁻¹.

A detectable threshold for the step-changes may be 1mA of implied current. A detectable threshold for the step-changes may be substantially less than 1mA, for example, 500μA or less, even 250μA or less, e.g., the detectable threshold might be of the order of 100μA.

Transient current inhomogeneities are believed to result from charge flowing across the gap between adjacent electrodes over a small area, and so concentrated charge travels generally perpendicular to the electrode surfaces. The change in magnetic field resulting from this flow of charge will be predominantly in x and y directions perpendicular to a normal of the electrode surface. The dispersal of the charge over the area of the electrode will produce a much lower current and a much lower magnetic field. Therefore, monitoring changes of the x-component and y-component of the magnetic field can detect the step-changes associated with the transient current inhomogeneities more easily and reliably than for changes in the z-component of the magnetic field. Greater sensitivity allows the method to be used to identify transient current inhomogeneities where less current has passed between electrodes.

A plurality of step-changes may be identified in a given temporal profile. The step-changes may be a first and second step-change associated with a start and finish point of a single transient current inhomogeneity. The plurality of step-changes may correspond to a plurality of transient current inhomogeneities.

A background magnetic field may be excluded from the temporal profiles.

Background magnetic field may be excluded from the temporal profiles by positioning the electrochemical cell and the one or more magnetometers in a magnetically shielded environment while the magnetometers measure the magnetic field generated by the electrochemical cell. Background magnetic field may be excluded from the temporal profiles by measuring the background magnetic field using a background magnetometer (or magnetometers) located distally from the electrochemical cell while the one or more magnetometers measure the magnetic field generated by the electrochemical cell, and subtracting the background magnetic field from the cell-measuring magnetometer measurements before providing the temporal profiles.

The magnitude of the change in magnetic field caused by a transient current inhomogeneity may be masked by background magnetic fields, for example, caused by the Earth's magnetic field or stray magnetic fields from nearby equipment. Reducing the noise in the data obtained by the cell magnetometers by excluding the background magnetic field therefore increases the likelihood of observing the effects of the transient current inhomogeneity in the data and the accuracy of its measurement.

The method may comprise identifying two or more transient current inhomogeneities within the temporal profiles, wherein the characteristic is a number of transient current inhomogeneities per time per electrochemical cell area or volume, e.g., the number of transient current inhomogeneities per hour, or the mean time between the beginning of transient current inhomogeneities per cell area or volume.

The time between transient current inhomogeneities, and so the frequency of transient current inhomogeneities, indicates how quickly an electrochemical cell will degrade. It therefore provides a measure of quality and efficiency, allowing performance of cells to be optimised by seeking to increase the time between transient current inhomogeneities, or reduce the frequency of transient current inhomogeneities.

The time of occurrence of a transient current inhomogeneity may be the time at which the step-change in the temporal profile is initiated.
The temporal profile may comprise a significant change in the opposite direction corresponding to an end in the transient current inhomogeneity. The time between transient current inhomogeneities may be taken between the initial step corresponding to each transient current inhomogeneity, i.e., a frequency of a transient current inhomogeneity occurring (and not involve the significant change corresponding to the end of a transient current inhomogeneity). Or the time between transient current inhomogeneities may be taken between the time of the finish of one and the start of another.

Confirming occurrence of a transient current inhomogeneity may comprise identifying a discontinuity in a temporal profile, wherein the discontinuity comprises a region within the temporal profile defined between a first step-change and a second step-change, wherein the second step-change is in an opposite direction to the first step-change. Each step-change may have a magnitude of more than 3 pT. Each step-change may have a magnitude greater than 5 pT, or greater than 10 pT. Each step-change may have a magnitude lower than 100 pT, or lower than 50 pT. Each step-change may take place in a time period of less than 500 seconds. Each step-change may take place in a time period of less than 300 seconds. Each step-change may take place in a time period of less than 100 seconds. Each step-change may take place in a time period of more than 10 seconds. Thus, each step change may have a rate of change of magnetic field greater than 6 $fTs^{-1}$, greater than 16 $fTs^{-1}$, greater than 33 $fTs^{-1}$, or greater than 0.1 $pTs^{-1}$.

The discontinuity may therefore be defined between a first point where a rate of change in the magnetic field exceeds a predetermined value while a change in the magnetic field (at the first point) exceeds a second predetermined value, and a second point where the rate of change in the magnetic field exceeds a third predetermined value while the change in the magnetic field (at the second point) exceeds a fourth predetermined value.

The magnetic field is step-changed for a period of time corresponding to the period of time that the current inhomogeneity occurs for. The discontinuity therefore occurs over a region of the temporal profile which indicates the length of time that the current inhomogeneity existed for. Identifying the discontinuity signature in the temporal profile increases the reliability of the detection of a current inhomogeneity compared to identifying a single step change, and increases the confidence with which the measured changes in the magnetic field can be attributed to transient current inhomogeneity, reducing the chance that a different phenomenon is mistakenly identified as a transient current inhomogeneity. Comparing the first temporal profile with the second temporal profile assists with this since the step-changes should be observable in both temporal profiles.

The characteristic may be a duration of transient current inhomogeneity, or a duration of transient current inhomogeneities per time. For example, the region within the temporal profile defined between a first step-change and a second step-change may have a duration of greater than one hour.

The duration of a transient current inhomogeneity event may be considered as the burn out time of the transient current inhomogeneity in that the transient current inhomogeneity lasts until material causing the transient current inhomogeneity breaks up and no longer provides a connection between electrodes to act as a charge transfer path. The duration of a transient current inhomogeneity may be linked to degradation rate of the cell. The duration of a transient current inhomogeneity may be indicative of the damage caused to the cell by the transient current inhomogeneity. The duration may also provide an indication of the amount of discharge of the cell caused by the transient current inhomogeneity or a typical transient current inhomogeneity. Characterising an electrochemical cell based on the duration can provide an indicator of quality, and/or battery lifetime, battery efficiency etc.

The method may comprise: positioning, at a second location, one or more magnetometers adjacent to the electrode surface of the electrochemical cell to measure magnetic field of the electrochemical cell at the second location;

measuring the magnetic field generated by the electrochemical cell at the second location for the predetermined length of time, the measuring providing a temporal profile of an x-component of the magnetic field and/or a temporal profile of a y-component of the magnetic field at the second location; and using the temporal profile(s) of the x- and/or y-components to identify a location of the transient current inhomogeneity when determining a characteristic of the electrochemical cell.

There may be a pair of magnetometers, each positioned at one of the first and the second locations, and each having the capability of measuring the magnetic field in two, non-parallel directions (e.g., each magnetometer measuring components of magnetic field in the x- and y-directions). The magnetometers may be spaced in one of the x- and y- directions with respect to the other to measure the magnetic fields at the two locations. The magnetometers may be positioned on opposite sides of a centre line of the electrochemical cell, for example, in the case of a planar cell. In one arrangement, one magnetometer may be positioned at a quarter or one-third region of the cell, and the other magnetometer may be positioned at a two-thirds or three-quarters region of the cell. Additional magnetometers may be positioned beyond opposite edges of the cell, for example, to provide a row of magnetometers extending over the electrochemical cell and beyond the edges at each side.

Measurements of each magnetometer may be affected by a transient current inhomogeneity at the same time so that the step-changes occur at the same time in each temporal profile. Comparisons between the temporal profiles associated with each magnetometer position may be drawn to analyse the transient current inhomogeneity and determine a characteristic. Identifying a concurrent step change in the temporal profile associated with different locations increases the reliability of the detection of a current inhomogeneity compared to identifying a step change at a single location, and increases the confidence with which the measured changes in the magnetic field can be attributed to transient current inhomogeneity, reducing the chance that a different phenomenon is mistakenly identified as a transient current inhomogeneity.

Furthermore, two or more locations for magnetometers may be used to determine a location of a defect giving rise to the transient current inhomogeneity. The location may be two-dimensional and determined in coordinates based on the x-direction and the y-direction, that is, the location is provided within an x-y plane. The position may include a coordinate based on a z-direction, perpendicular to the x-direction and the y-direction (parallel to a normal of the electrode surface) when three or more locations for magnetometers are used to determine a location of a defect giving rise to a transient current inhomogeneity.

Magnetometers positioned over portions of the electrochemical cell may be referred to herein as cell-measuring magnetometers, to differentiate over magnetometers arranged at locations away from the cell (which may be implemented in the removal of background magnetic field for example). The cell-measuring magnetometers are able to observe the changes in magnetic field locally, at the electrode surface through being positioned adjacent the electrochemical cell.

The method may comprise: determining a vector change in magnetic field corresponding to the transient current inhomogeneity at the first location; determining a vector change in magnetic field corresponding to the transient current inhomogeneity at the second location; and determining a location of the transient current inhomogeneity using a geometric determination whereby an intersection point of an imaginary line extending from each of the first and second locations in a direction orthogonal to the change in the magnetic field at the first and second locations provides the location of the transient current inhomogeneity.

Determining a position of (i.e. locating) the transient current inhomogeneity in the plane of the electrodes allows for analysis of distribution of the transient current inhomogeneities across the electrodes.

Locating the transient current inhomogeneity in a direction perpendicular to the electrodes allows a determination of which electrodes in a stack of electrodes the transient current inhomogeneity occurred between.

Locating allows for analysis of geometrical influences on the occurrence of transient current inhomogeneity and on the degradation rate. It also allows for the confinement of the transient current inhomogeneity to certain electrodes or areas of electrodes to be assessed and so faults in certain areas can be identified.

The vector change in magnetic field may be a two-dimensional vector change. This may be calculated as the difference between the x-component and y-component of the magnetic field with and without the occurrence of the transient current inhomogeneity. The change in field caused by the transient current inhomogeneity may then be represented in orthogonal x- and y- directions and the position of the transient current inhomogeneity can be determined in two-dimensions. In the case where the electrochemical cell comprises a single anode layer and a single cathode layer, the position of the transient current inhomogeneity in the orthogonal, z direction may be known as it will be within the separation of the anode and cathode layers.

The vector change in magnetic field may be a three-dimensional vector change. This may be calculated as the difference between a three-dimensional vector field with and without the occurrence of the transient current inhomogeneity. The change in field caused by the transient current inhomogeneity may then be represented in orthogonal x, y and z directions. The position of the transient current inhomogeneity can then be determined in three dimensions using measurements provided by magnetometers measuring the three-dimensional magnetic field at two locations.

The method may comprise: positioning one or more magnetometers adjacent to the electrochemical cell to measure magnetic field of the electrochemical cell at a third location; measuring the magnetic field generated by the electrochemical cell at the third location for the predetermined length of time, the measuring providing a temporal profile of the x-component of the magnetic field and/or the y-component of the magnetic field at the third location; determining a vector change in the magnetic field corresponding to the transient current inhomogeneity, as measured at the first, second and third locations, and determining a location of the transient current inhomogeneity based on the vector changes at the first, second and third locations.

The geometric determination may require forming an imaginary sphere around each magnetometer and determining an intersection point of the three imaginary spheres. The distance between each magnetometer and the surface of their respective sphere may be determined by the proportional magnitude of the vector change in the magnetic field measured by the respective magnetometer relative to the magnitude of the vector change in the magnetic field measured by each of the other magnetometers. The vector changes may be three-dimensional vector changes.

The method may comprise: determining a vector change in magnetic field at a first and second location caused by the transient current inhomogeneity; determining the location and magnitude of the current inhomogeneity by applying the vector change at the first and second location to Biot-Savart's Law described below.

The method may comprise: determining a vector change in the magnetic field at the first location over a duration of the transient current inhomogeneity; determining a charge transferred by the transient current inhomogeneity based on the magnitude of the vector change in magnetic field, a perpendicular distance between an anode layer and an adjacent cathode layer within the electrochemical cell, and a distance between the first location and the location of the transient current inhomogeneity.

The vector change in the magnetic field is the difference in magnitude and direction between a vector field before the occurrence of the transient current inhomogeneity, and a vector field during the occurrence of the transient current inhomogeneity. The vector change in the magnetic field at the first location over a duration of the transient current inhomogeneity may be approximated as being equal to the vector change in the magnetic field at the beginning or end of the transient current inhomogeneity for the duration of the transient current inhomogeneity. The vector change in the magnetic field at the first location over a duration of the transient current inhomogeneity may be approximated as being equal to a smooth change, for the duration of the transient current inhomogeneity, between the vector change in the magnetic field at the beginning of the transient current inhomogeneity and at the end of the transient current inhomogeneity. The vector change in the magnetic field at the first location over a duration of the transient current inhomogeneity may be approximated by approximating a drift in the magnetometer measurements absent the transient current inhomogeneity, and determining the vector change in the measured field over the duration of the transient current inhomogeneity and the approximated drift.

The magnitude of the magnetic field produced by a current is proportional to the magnitude of the current. Therefore, integration of the field change over time, enables a measure of charge transferred to be determined.

The perpendicular distance between an anode layer and an adjacent cathode layer may be the shortest separation between the anode layer and cathode layer and may represent the distance over which the charge was transferred during the transient current inhomogeneity.

The distance between the first location and the position of the defect giving rise to the transient current inhomogeneity may be the minimum, straight-line distance.

The vector change in magnetic field may be a three-dimensional vector change.

The characteristic of the electrochemical cell may be one or more of: charge transferred per transient current inhomogeneity, charge transferred by transient current inhomogeneities per time per area or volume.

The method may comprise: determining a vector change in magnetic field corresponding to the transient current inhomogeneity at each magnetometer location; determining a field ratio as the ratio of the magnitude of the vector change in magnetic field strength at the first location and the magnitude of the vector change in magnetic field strength at the second location; determining a distance ratio as the ratio of a distance between the first location and the location of the transient current inhomogeneity and a distance between the second location and the location of a transient current inhomogeneity, comparing the field ratio and distance ratio; and if the product of the field ratio and the distance ratio is between 0.9 and 1.1, attributing, with a 95% confidence interval, the transient current inhomogeneity to a single point-like transient defect within the electrochemical cell.

The method may comprise: identifying a plurality of step-changes within the temporal profiles to identify one or more discontinuities, each between a first step-change and a second step-change in an opposite direction to the first step-change, each of the discontinuities occurring at a respective coincident time across the temporal profiles; determining a spatial and temporal distribution of transient current inhomogeneities based on measurements obtained by the magnetometers relating to each discontinuity.

The characteristic may relate to an area of electrode affected by transient current inhomogeneities over time per area of electrode, or a concentration in the distribution of electrode area affected by transient current inhomogeneities over time. This characteristic allows for a determination of whether the transient current inhomogeneities are occurring randomly, in space and time, or non-homogeneously in space and time.

The plurality of discontinuities may have overlapping regions, and the method may comprise: determining a spatial and temporal distribution of transient current inhomogeneities based on measurements obtained by the magnetometers relating to each discontinuity. This would be performed by sequentially applying the discrete step changes to the magnetic field measurements to determine the location and magnitude of each current inhomogeneity.

The durations of the transient current inhomogeneities may overlap and so the change in magnetic field at a magnetometer location may be affected simultaneously by a plurality of transient current inhomogeneities. By tracking the start and end of each step-change in the magnetic field, a cumulative pattern of the evolution of the current inhomogeneities can be produced.

The method may comprise providing a rating of an electrochemical cell based on a characteristic, or a combination of, characteristics.

For example, the characteristic may be rate of occurrence of transient current inhomogeneities per time per electrochemical cell volume and an electrochemical cell having a higher rate of occurrence of transient current inhomogeneities per time per electrochemical cell volume may be given a less favourable rating than an electrochemical cell having a lower rate. As another example, the characteristic may be a number of charge/discharge cycles before the number (or rate of occurrence per time) of transient current inhomogeneities reaches a threshold level, and the rating may be more favourable for an electrochemical cell having a higher number of charge/discharge cycles before the number (or rate of occurrence per time) of transient current inhomogeneities reaches the threshold level.

Confirming a transient current inhomogeneity may include analysing the temporal profile to identify a discontinuity within the temporal profile, a discontinuity comprising a region within the temporal profile may be defined between a first step-change and a second step-change, wherein the second step-change is in an opposite direction to the first step-change; and the duration of the region is greater than one hour.

The predetermined length of time for measuring the changes in the magnetic field may be greater than 12 hours.

The electrochemical cell may be one of a pouch cell, prismatic cell and a cylindrical cell.

The electrochemical cell may comprise lithium and/or lithium ions.

The one or more magnetometers may be quantum magnetometers (optionally one of optically pumped quantum magnetometers (OPMs) and super conducting quantum interference device (SQUIDS)).

It will be appreciated that the plurality of cell-measuring magnetometers, and the background magnetometer, may be any magnetometers having a suitable sensitivity. These may include, but are not limited to: fluxgates; OPMs; Hall probes; magneto-resistive sensors; and magneto-electric sensors. The sensitivity may be directional (x, x and y, or x, y and z). The sensitivity may be directional and may be in one or more dimensions. The sensitivity may be at least 10 pT Hz$^{-1/2}$, for example the sensitivity may be 5 pT Hz$^{-1/2}$. The magnetometers may be capable of detecting change in magnetic field of less than 1 pT, or less than 5 pT.

The method may comprise performing the measurement of the magnetic field generated by the electrochemical cell for a predetermined length of time a plurality of times, and between each measurement of the magnetic field generated by the electrochemical cell for a predetermined length of time charging and discharging the electrochemical cell a predetermined number of times. The characteristic may be a number of charge/discharge cycles before the number (or rate of occurrence per time) of transient current inhomogeneities reaches a threshold level.

The electrochemical cell may be heated to a predetermined temperature while the magnetometers measure the magnetic field generated by the electrochemical cell, and/or the electrochemical cell is charged to a predetermined state of charge while the magnetometers measure the magnetic field generated by the electrochemical cell, and/or the electrochemical cell is conditioned to a have predetermined state of health while the magnetometers measure the magnetic field generated by the electrochemical cell.

The characteristic may be the temperature at which the frequency of transient current inhomogeneities reaches a predetermined value or the state of charge or state of health at which the frequency of transient current inhomogeneities is highest or lowest.

The magnetometers may be provided in an array, (optionally a 1×3, 1×4, 2×3, 2×4, array etc. array of 8 or 16).

The electrochemical cell may be a planar electrochemical cell and magnetometers are positioned at four locations in a row across the electrochemical cell, with two magnetometers positioned over locations of the electrode surface, and two magnetometers positioned to locations at opposite, side edges of the electrochemical cell.

Magnetometers may be positioned on opposite surfaces of the electrochemical cell. For example, the first magnetometer location may be on one side of the electrochemical cell and the second magnetometer location may be on the opposite side of the electrochemical cell, whilst both magnetometers are aligned with an x-y plane of the electrodes.

The plurality of electrodes may comprise a stack of interleaved anode layers and cathode layers. Adjacent anode and cathode layers may be spaced by a distance of less than $25\mu m$.

In a second aspect, the present invention provides a method of characterising a condition of an electrochemical cell comprising a plurality of electrodes, the method comprising: positioning a magnetometer adjacent to an electrode surface of the electrochemical cell to measure magnetic field of the electrochemical cell at a first location; positioning a magnetometer adjacent to an electrode surface of the electrochemical cell to measure magnetic field of the electrochemical cell at a second location; measuring the magnetic field generated by the electrochemical cell for a predetermined length of time, the measuring providing a first temporal profile of a directional component of the magnetic field at the first location, and a second temporal profile of a directional component of the magnetic field at the second location; confirming occurrence of a transient current inhomogeneity within the electrochemical cell based on identifying a step-change in the first temporal profile and a coincident step-change in the second temporal profile; and determining a characteristic of the electrochemical cell based on the occurrence of transient current inhomogeneities.

In a third aspect, the present invention provides a method of characterising a condition of an electrochemical cell comprising a plurality of electrodes, the method comprising: positioning a magnetometer adjacent to an electrode surface of the electrochemical cell to measure magnetic field of the electrochemical cell ; using the magnetometer to measure the magnetic field generated by the electrochemical cell for a predetermined length of time, the measuring providing a first temporal profile of the magnetic field at the first location; confirming occurrence of a transient current inhomogeneity within the electrochemical cell based on identifying a discontinuity in the temporal profile, wherein the discontinuity comprises a region within the temporal profile defined between a first step change, and a second step-change, wherein the second step-change is in an opposite direction to the first step-change; and determining a characteristic of the electrochemical cell based on the occurrence of transient current inhomogeneities.

A background magnetic field may be excluded from the first temporal profile.

For example, by positioning the cell and cell-measuring magnetometer(s) in a magnetically shielded environment while the magnetometer measures the magnetic field generated by the electrochemical cell, or, by measuring the background magnetic field using a background magnetometer located distally from the electrochemical cell while the cell-measuring magnetometer measures the magnetic field generated by the electrochemical cell, and subtracting the background magnetic field from the cell-measuring magnetometer measurements before providing the temporal profiles.

The characteristic may be a number of transient current inhomogeneities per time per electrochemical cell area or volume, or a mean time between transient current inhomogeneities per area or volume, or a duration of transient current inhomogeneity per time, or average duration of transient current inhomogeneity, or a magnitude of a vector change in magnetic field during a transient current inhomogeneity, or a rate of change in the magnitude of a vector change in magnetic field during a transient current inhomogeneity.

The predetermined length of time for measuring the magnetic field may be greater than 12 hours, and/or a length of time of the region corresponding to a duration of the discontinuity is greater than one hour.

The plurality of electrodes may comprise an anode and an adjacent cathode, the method comprising: determining a vector change in the magnetic field measured by the cell magnetometer over the duration of the discontinuity; determining a charge transferred by the transient current inhomogeneity based on: the magnitude of the vector change in the magnetic field; a perpendicular distance between an anode and an adjacent cathode within the electrochemical cell; and a distance between the cell magnetometer and the location of the transient current inhomogeneity.

The characteristic of the electrochemical cell may comprise at least one or more of: charge transferred per transient current inhomogeneity, charge transferred by transient current inhomogeneities per time per area or volume.

The electrochemical cell may be one of a pouch cell, prismatic cell and a cylindrical cell.

The electrochemical cell may comprise lithium.

The electrochemical cell may be heated to a predetermined temperature while the magnetometer measures the magnetic field generated by the electrochemical cell, and/or the electrochemical cell is charged to a predetermined state of charge while the magnetometer measures the magnetic field generated by the electrochemical cell, and/or the electrochemical cell is conditioned to a predetermined state of health while the magnetometer measures the magnetic field generated by the electrochemical cell.

In a fourth, fifth and sixth aspect, the present invention may extend to a system for non-invasive characterisation of an electrochemical cell. It will be appreciated that such a system may be configured to carry out any of the methods described above in relation to the first, second and third aspect and that any of the above described methods may use any one or a combination of features of the systems described below.

In the fourth aspect, the present invention provides a system for non-invasive characterisation of an electrochemical cell comprising: one or more magnetometers configured to be disposed adjacent to the electrochemical cell at a first location, each of the one or more magnetometers having a sensitivity capable of measuring magnetic fields caused by internal currents of the cell in the passive state and the one or more magnetometers configured to provide a measure of magnetic field in an x-direction and a y-direction at the first location for a predetermined length of time, and a controlling and processing subsystem, wherein the controlling and processing subsystem is configured to: take measurements with the one or more magnetometers, for the predetermined length of time, of a magnetic field at the first location, and provide a first temporal profile of the magnetic field at the first location in the x-direction and a second temporal of the magnetic field at the first location in the y-direction; confirm occurrence of a transient current inhomogeneity within the electrochemical cell based on identifying a coincident step-change in the x-component and y-component of the magnetic field from each temporal profile; and determine a characteristic of the electrochemical cell based on the occurrence of transient current inhomogeneities.

The system may comprise one or more magnetometers configured to be disposed adjacent to the electrochemical cell at a second location, each of the one or more magnetometers having a sensitivity capable of measuring magnetic fields caused by internal currents of the cell in the passive state and the one or more magnetometers configured to provide a measure of magnetic field in the x-direction or the predetermined length of time. The controlling and processing subsystem may be configured to take measurements with the one or more magnetometers, for the predetermined length of time, of a magnetic field at the second location; provide a temporal profile of the x-component of the magnetic field and/or the y-component of the magnetic field at the second location; and use the temporal profile(s) of the x- and/or y-components to identify a location of the transient current inhomogeneity when determining a characteristic of the electrochemical cell.

The system may comprise one or more magnetometers configured to be disposed adjacent to the electrochemical cell at a third location, each of the one or more magnetometers having a sensitivity capable of measuring magnetic fields caused by internal currents of the cell in the passive state and the one or more magnetometers configured to provide a measure of magnetic field in the x-direction or the predetermined length of time. The controlling and processing subsystem may be configured to take measurements with the one or more magnetometers, for the predetermined length of time, of a magnetic field at the third location; provide a temporal profile of the x-component of the magnetic field and/or the y-component of the magnetic field at the third location; determine a vector change in the magnetic field corresponding to the transient current inhomogeneity, as measured at the first, second and third locations; and determine a location of the transient current inhomogeneity based on the vector changes at the first, second and third locations.

The system may comprise a structure on which the one or more magnetometers are mounted. The structure may be configured such that by arranging the electrochemical cell within or against the structure, the one or more magnetometers to assume a predetermined orientation in respective first, second or third locations relative to the orientation of the electrochemical cell.

In the fifth aspect, the present invention provides a system for non-invasive characterisation of an electrochemical cell comprising: a plurality of magnetometers, wherein the magnetometers are configured to be disposed adjacent to the cell and have a sensitivity such that they are capable of measuring magnetic fields caused by internal currents of the cell in the passive state and configured to provide a measure of magnetic field for a predetermined length of time, and a controlling and processing subsystem, wherein the controlling and processing subsystem is configured to: take measurements with each respective magnetometer of a magnetic field local to each magnetometer, and provide temporal profiles of a directional component of the magnetic field local to each magnetometer; confirm occurrence of a transient current inhomogeneity within the electrochemical cell based on identifying a coincident step-change in a directional-component of the magnetic field from each temporal profile; and determine a characteristic of the electrochemical cell based on the occurrence of transient current inhomogeneities.

The system may comprise a plurality of magnetometers

The system may comprise a structure on which the plurality of magnetometers are mounted. The structure may be configured such that by arranging the electrochemical cell within or against the structure the plurality of magnetometers assume a desired orientation relative to the orientation of the electrochemical cell.

In the sixth aspect, the present invention provides a system for non-invasive characterisation of an electrochemical cell comprising: a magnetometer configured to be disposed adjacent to the electrochemical cell, the magnetometer having a sensitivity capable of measuring magnetic fields caused by internal currents of the cell in the passive state and configured to provide a measure of magnetic field over a predetermined length of time, and a controlling and processing subsystem, wherein the controlling and processing subsystem is configured to: take measurements with the magnetometer for the predetermined length of time, and provide a temporal profile of the magnetic field; confirm occurrence of a transient current inhomogeneity within the electrochemical cell based on identifying a discontinuity in the temporal profile, wherein the discontinuity comprises a region within the temporal profile defined between a first step-change and a second step-change, wherein the second step-change is in an opposite direction to the first step-change; and determine a characteristic of the electrochemical cell based on the occurrence of transient current inhomogeneities.

The system may comprise a structure on which the magnetometer is mounted. The structure may be configured such that by arranging the electrochemical cell within or against the structure the magnetometer assumes a desired orientation relative to the orientation of the electrochemical cell.

The following features may be applied to any and each of the fourth, fifth and sixth aspects above.

The magnetometers may be quantum-based magnetometers such as optically pumped magnetometers (OPMs), super conducting quantum interference device (SQUIDS). It will be appreciated that the plurality of cell-measuring magnetometers, and where present, the background magnetometer, may be any magnetometers having a suitable sensitivity. These may include, but are not limited to: fluxgates; OPMs; Hall probes; magneto-resistive sensors; and magneto-electric sensors. The sensitivity may be directional and may be in one or more dimensions. The sensitivity may be at least $10\,pT\,Hz^{-1/2}$, for example the sensitivity may be $5\,pT\,Hz^{-1/2}$. The magnetometers may be capable of detecting change in magnetic field of less than 1 pT, or less than 5 pT.

The system may comprise a magnetic shield for shielding an environment from background magnetic field noise.

The system may alternatively, or additionally, comprise a background magnetometer. The background magnetometer may be configured to be disposed distally from the electrochemical cell while the cell-measuring magnetometers measure the magnetic field generated by the electrochemical cell. The controlling and processing subsystem may be configured to take measurements of the background magnetic field with the background magnetometer simultaneously with the measurements taken using the cell-measuring magnetometers, and subtract the background magnetic field from the cell-measuring magnetometer measurements before providing the temporal profiles.

The system may comprise a heating system configured to maintain the electrochemical cell at a predetermined temperature during measurement of the magnetic field for the predetermined length of time.

The heating system may comprise a heating element and a processor for controlling the heating element, and may comprise a temperature sensor for monitoring the temperature of the electrochemical cell so that the processor is able to control the heating element in response to the temperature of the electrochemical cell so that the desired temperature of the electrochemical cell is maintained.

The system may comprise a charge cycling unit configured to be connected to the electrochemical cell to control the charge within the electrochemical cell. The charge cycling unit may place the electrochemical cell in a predetermined state of charge prior to the measuring of the magnetic field generated by the electrochemical cell. The charge cycling unit may charge and the electrochemical cell or discharge the electrochemical cell until the predetermined state of charge is reached. The system may comprise a means for detecting the state of charge of the electrochemical cell.

The charge cycling unit may repeatedly charge and discharge the electrochemical cell in order to place the electrochemical cell in a predetermined state of charge and predetermined state of health. The controlling and processing subsystem may be configured to control the charge cycling unit.

The system may comprise a conditioning unit configured to be connected to the electrochemical cell to place the electrochemical cell in a predetermined state of health. The system may comprise a means for detecting the state of health of an electrochemical cell. The controlling and processing subsystem may be configured to control the conditioning unit.

Certain example embodiments will now be described by way of example only and with reference to the accompanying drawings, in which:

> Figure 1 shows a schematic view of an electrochemical cell characterising system;
> Figure 2 shows a perspective view of an electrochemical cell and two magnetometers;
> Figures 3a and 3b show example temporal profiles of magnetic field;
> Figure 3c shows an example magnetometer configuration, and figure 3d shows a temporal profile obtained from the magnetometer configuration of figure 3c;
> Figure 4 shows a cross section of an electrochemical cell, and an inset showing a representation of a transient current inhomogeneity within the cell;
> Figure 5 shows a schematic of the principles of determining a position of a transient current inhomogeneity;
> Figures 6a to 6d show structures on which magnetometers are mounted;
> Figure 7 shows a system for non-invasive characterisation of an electrochemical cell.

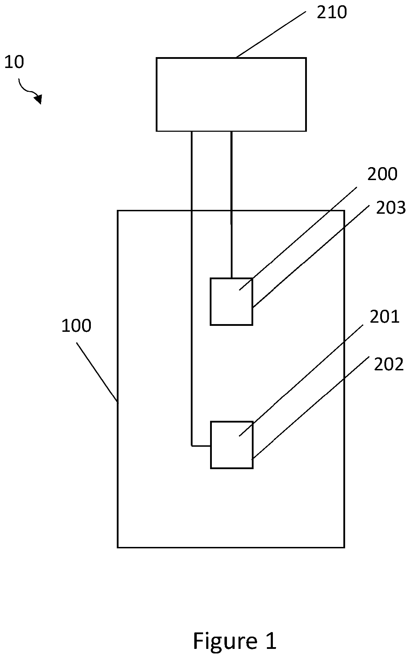

Figure 1 shows a system for non-invasive characterisation of an electrochemical cell. The system uses magnetometers 200, 201 positioned adjacent to an electrochemical cell 100. The first magnetometer 200 is positioned adjacent to the electrochemical cell and at a first location 202, and the second magnetometer 201 is positioned adjacent to the electrochemical cells and at a second location 203. The individual magnetometer readings are provided to a controlling and processing subsystem 210 for providing temporal profiles of the magnetic field at each location.

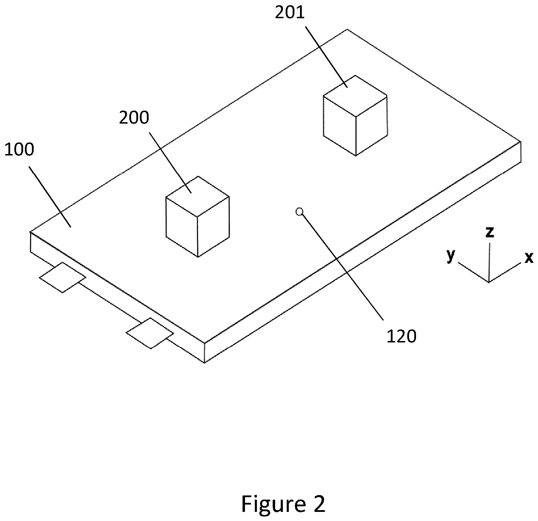

Figure 2 shows a perspective view of the electrochemical cell 100, and for the purpose of illustration only, a circle represents the occurrence of a current inhomogeneity 120 which occurs within the electrochemical cell 100 substantially as a point-like defect.

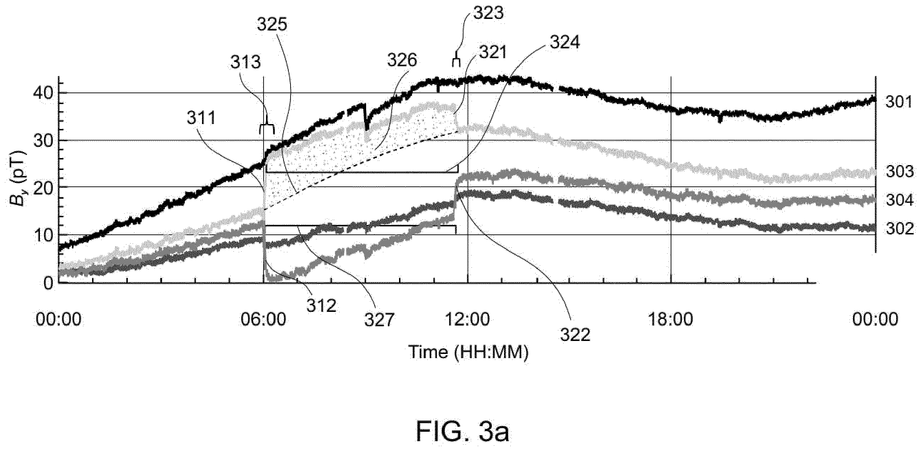

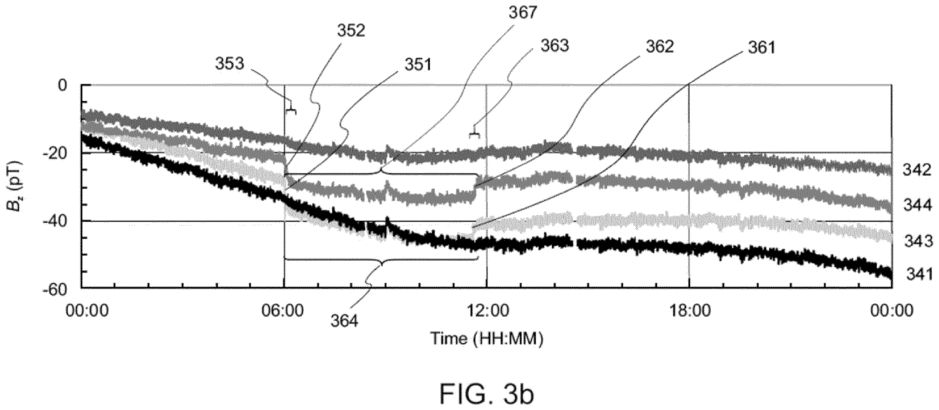

Figures 3a and 3b show exemplary temporal profiles obtained during a single test of a single electrochemical cell (the test being a monitoring the magnetic field in the passive state, in some cases following an induced charge or discharge event, in other cases without inducing a charge or discharge event, in other cases after manufacture and before use). Temporal profiles are traces that show magnetic field data obtained by a magnetometer over time. That is, temporal profiles are constructed to represent two or more of $B_{x1}$, $B_{x2}$, $B_{y1}$, and $B_{y2}$ over time. Temporal profiles labelled 301 and 341 show data obtained by a first background magnetometer and the temporal profiles labelled 302 and 342 show data obtained by a second background magnetometer. The first and second background magnetometer are positioned distally from the electrochemical cell. Temporal profiles labelled 303 and 343 show data obtained by a magnetometer at a first location adjacent the electrochemical cell and the temporal profiles labelled 304 and 344 show data obtained by a magnetometer at a second location adjacent the electrochemical cell.

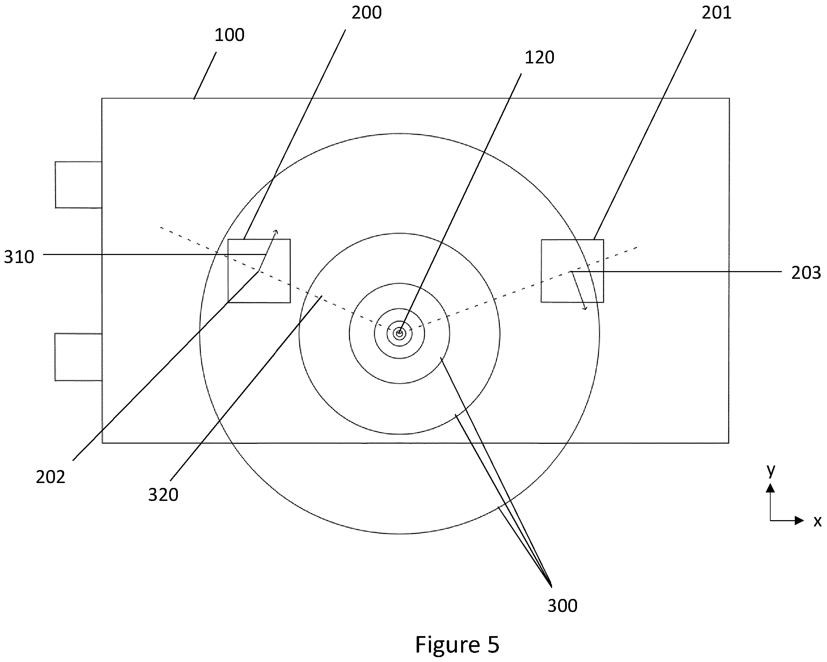

Figure 3a shows temporal profiles of a y-component of the magnetic field, whereas figure 5b shows temporal profiles of a z-component of the magnetic field.

In figure 3a, at approximately 6:00 hours a step-change, indicated at 311 and 312 can be seen in each of the temporal profiles associated with magnetometer locations adjacent the electrochemical cell (i.e. temporal profiles 303 and 304 respectively). A steep gradient in the temporal profile has a duration 313 of approximately 5 minutes. The change in magnitude of the magnetic field measured by the magnetometer at the first location adjacent the electrochemical cell resulting from the steep gradient is approximately 10 pT. The change in magnitude of the magnetic field measured by the magnetometer at the second location adjacent the electrochemical cell resulting from the steep gradient is approximately 11 pT. The high change in magnetic field over the short duration of time allows the step-change to be detected. In figure 3a, the step-change 311 in the temporal profile 303 of the y-component of magnetic field associated with the first location occurs at coincident time as the step-change 312 in the temporal profile 304 of the y-component of magnetic field associated with the second location. By identifying this co-occurrence, the occurrence of a transient current inhomogeneity can be confirmed.

At approximately 11:30, step-changes 321, 322 can be seen in the temporal profile associated with magnetometer locations adjacent the electrochemical cell (i.e. temporal profiles 303 and 304 respectively). Again, the duration 323 of these is approximately 5 minutes. The change in magnitude associated with the steep gradients seen at 321 and 322 are such that a step-change can be identified within the profile.

A discontinuity 324 in the temporal profile of the magnetometer at the first location occurs between step changes 311 and 321. The discontinuity 324 therefore exists for a duration of approximately 5 hours 30 minutes. A discontinuity 324 is termed as such since the temporal profile substantially resumes a profile commensurate with the background field profiles once the effect of the transient current inhomogeneity is no longer measured. That is, the temporal profiles seemingly return to where they would have been had the transient current inhomogeneity not occurred. The occurrence of a discontinuity (i.e. the first step-change 311 being counteracted by a second step-change 321 after a period of time) allows a current inhomogeneity to be confirmed.

The discontinuity 324 in the temporal profile 303 of the first magnetometer location occurs at the same time and for the same length of time as a discontinuity 327 in the temporal profile 304 of the magnetometer at the second location (in the same filed direction). This co-occurrence can be used to verify the occurrence of a transient current inhomogeneity.

The area 326 contained by the discontinuity 324 (i.e. the area 326 contained between an expected baseline trace 325 of the temporal profile 303 absent the step-changes 311, 321, and the measured temporal profile in the region of the discontinuity 314) is proportional to the charge transferred during the occurrence of the transient current inhomogeneity.

In figure 3b, at approximately 6:00 hours a step-change, indicated at 351 and 352 can be seen in each of the temporal profiles associated with the z-component of magnetic field measured at magnetometer locations adjacent the electrochemical cell (i.e. temporal profiles 343 and 344 respectively). A steep gradient in the temporal profiles 343, 344 has a duration 353 of approximately 5 minutes. The change in magnitude of the magnetic field measured by the magnetometer at the first location adjacent the electrochemical cell resulting from the steep gradient is approximately 10 pT. The change in magnitude of the magnetic field measured by the magnetometer at the second location adjacent the electrochemical cell resulting from the steep gradient is approximately 9 pT. The high change in magnetic field over the short duration of time allows the step-change to be identified.

In figure 3a and 3b, the step-change 311 in the y-component of magnetic field in the temporal profile 303 associated with the first location, occurs at a coincident time as the step-change 351 in the z-component of magnetic field in the temporal profile 343 associated with the first location. By identifying this, the occurrence of a transient current inhomogeneity can be verified. Similarly, identifying a coincident step-change 351 in the z-component of magnetic field in the temporal profile 343 associated with the first location, and a step-change 312 in the y-component of magnetic field in the temporal profile 304 associated with the second location, allows for verification of a transient current inhomogeneity.

Again, at approximately 11:30, step-changes 361, 362 can be seen in the temporal profile associated with magnetometer locations adjacent the electrochemical cell (i.e. temporal profiles 343 and 344 respectively). Again, the duration 363 of these is approximately 5 minutes. The change in magnitude associated with the steep gradients seen at 361 and 362 are such that a step-change can be identified within the profile.

In figure 3b, a discontinuity 364 in the temporal profile 343 of the magnetometer at the first location occurs between step changes 352 and 362. The discontinuity 364 therefore exists for a duration of approximately 5 hours 30 minutes.

The discontinuity 324 in the temporal profile of the y-component of magnetic field measured by the magnetometer at the first location occurs at the same time as the discontinuity 364 in the z-component of magnetic field measured by the magnetometer at the first location. This co-occurrence can be used to verify the occurrence of a transient current inhomogeneity.

The discontinuity 324 in the temporal profile 303 of the y-component of magnetic field measured by the magnetometer at the first location occurs at the same time as a discontinuity 367 in the temporal profile 344 of the z-component of magnetic field measured by the magnetometer at the second location. This co-occurrence can be used to verify the occurrence of a transient current inhomogeneity.

The area 326 contained by the discontinuity 324 (i.e. the area 326 contained between an expected baseline trace 325 of the temporal profile 303 absent the step-changes 311, 321, and the measured temporal profile 303 in the region of the discontinuity 314) is proportional to the charge transferred during the occurrence of the transient current inhomogeneity.

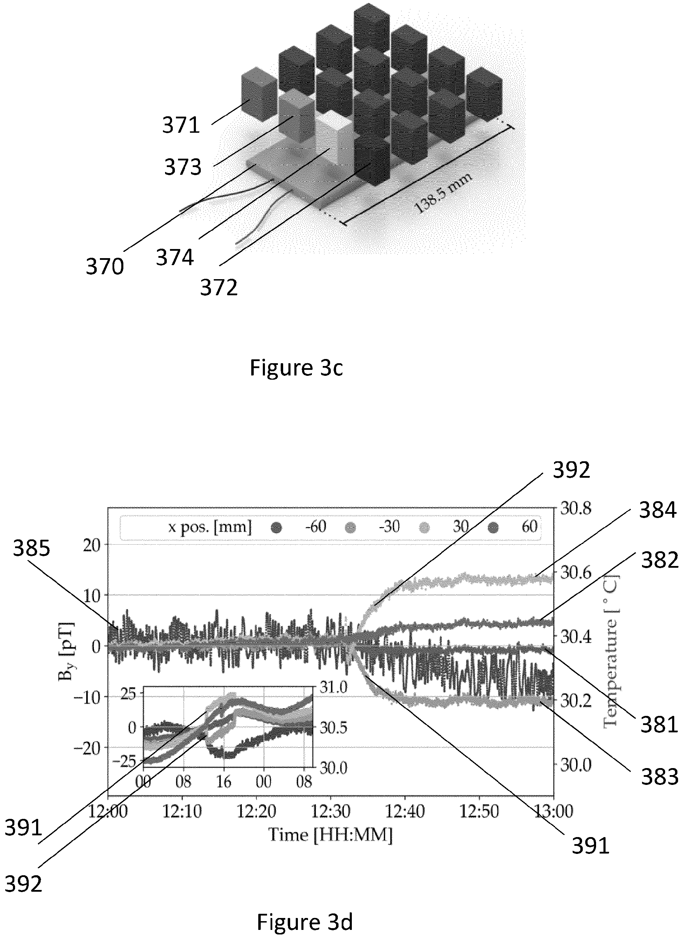

Figure 3c shows a pouch cell 370 and an example of a magnetometer configuration for measuring the magnetic field generated by the electrochemical cell 370. A first background magnetometer 371 is positioned distally from the electrochemical cell 370, such that the magnetometer is not above the plane of the electrochemical cell 370 and predominantly measures the background magnetic field without being influenced by the magnetic field of the electrochemical cell 370. A second background magnetometer 372 is positioned distally from the electrochemical cell 370 in order to measure the background magnetic field on the opposite edge of the electromagnetic cell 370 to the first background magnetometer 371.

A magnetometer 373 is positioned at a first location adjacent the electrochemical cell 370, a second magnetometer 374 is positioned at a second location adjacent the electrochemical cell 370. Both magnetometers 373 and 374 are above the plane of the pouch cell. The magnetometers 373 and 374 measure at least the y-component of the magnetic field produced by the electrochemical cell in a passive state. The y-direction being a direction parallel to a direction in the plane of the pouch cell.

Figure 3d shows exemplary temporal profiles of a y-component of magnetic field obtained during a single test of electrochemical cell 370. Temporal profiles 381 and 382 show the background magnetic field measured by magnetometers 371 and 372 respectively. Temporal profiles 383 and 384 show the y-component of magnetic field measured by magnetometers 373 and 374 respectively. The inset of figure 3d shows the temporal profiles over a 32-hour period. Step changes 391 and 392 can be seen in the temporal profiles 383 and 384. The main figure 3d shows the temporal profiles magnified at the region of the step changes 391, 392 by showing a time period of 1 hour.

Included in the main figure 3d and its inset is a temporal profile 385 of the temperature of the electrochemical cell for the same period of time. A notable reduction in temperature begins at the same time as the step changes in the temporal profiles of magnetic field measured at the first and second locations. Identification of coincidence of an onset of a temperature reduction and a step change in the temporal profile of the magnetic field may be used to verify the detection and/or confirmation of a transient current inhomogeneity with the electrochemical cell.

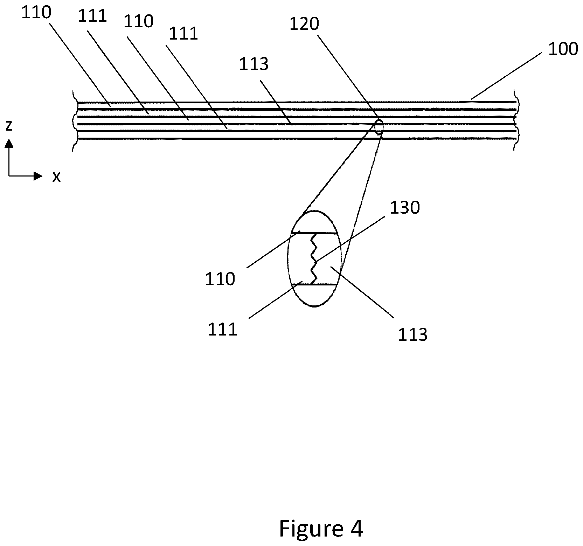

Figure 4 shows a schematic, partial cross section of the electrochemical cell 100 including an x-direction and a z-direction of the cell. Inside the casing of the electrochemical cell 100 is a layered electrode structure, comprising anode layers 111 and cathode layers 110. The schematic shows two anode layers 110 and two cathode layers 111, however in reality the electrochemical cell may comprise more of each of the layers in an alternating configuration. The electrodes extend in an x-y plane. The x-, y-, and z- directions are orthogonal.

The anode layers 110 and cathode layers 111 alternate so that a stack is formed. The illustrated cell may be a pouch cell in which each of the anode layers 110 and each of the cathode layers 111 are formed from individual electrodes. The illustrated cell may be a prismatic or cylindrical cell in which a single anode and cathode pair are wound and/or folded so that when viewed locally, a stack of electrodes is formed.

Adjacent anode and cathode layers are separated by an interlayer spacing in the z-direction, typically this spacing is tens of $\mu$m. In the configuration shown in figure 3, the z-direction is aligned with the direction perpendicular to the electrode surfaces, i.e. the surface normal. The distance in the z-direction is therefore the shortest distance between the two electrodes.

Adjacent anode and cathode layers are separated by a layer of electrolyte 103 within the interlayer spacing. The electrodes are comprised of highly conductive material, whereas the electrolyte 103 is significantly less conductive. Material within the electrolyte can accumulate on the surfaces of the electrodes, in particular on the anode layers 110. Even with the electrochemical cell in a passive state, it is thought that material builds up to the extent that a high conductivity path 130 is created between an adjacent anode layer 110 and cathode layer 111. The effect is that for a finite time the conductivity in a specific position $(x_d, y_d)$ is high along a finite length path parallel to the z-axis. Charge flows along the transient high-conductivity path 130 causing a current inhomogeneity in the electrochemical cell 100. The material disperses over time so that a complete conductive path no longer exists, the current no longer flows, and the current inhomogeneity ceases, hence it is a transient high-conductivity path 130 which causes a transient current inhomogeneity. While the transient current inhomogeneity is active, damage is caused to the regions on the electrode surfaces that contact the material build up.

In this passive state degradation mode, a current therefore flows in the z-direction, and following Ampère's circuital law and the 'right hand grip rule', a magnetic field is produced in the x- and y- directions.

The central position in the z direction (i.e. half way along the inter-layer spacing) of the transient high-conductivity path 130 is $z_d$. The length of the transient high-conductivity path 130 is L, L being equal to the inter-layer spacing of the electrodes.

The coordinates $(x_d, y_d, z_d)$ of the centre of the transient high-conductivity path, the conductivity of the transient high-conductivity path, and the charge transferred during the existence of the transient high-conductivity path 130 can be determined using measurements of the magnetic field obtained by the first and second magnetometers 200, 201.

Measurements from the first and second magnetometers are provided as, or resolved into, the component of the magnetic field in the x-direction (i.e. the magnitude of the magnetic field in the x-direction) and in the y-direction (i.e. the magnitude of the magnetic field in the y-direction). The change in magnetic field in the x-direction and in the y-direction is then determined. $B_{x1}$ is the magnitude of the change in magnetic field in the x-direction, and $B_{y1}$ is the magnitude of the change in magnetic field in the y-direction, as determined using the magnetometer at the first location. $B_{x2}$ and $B_{y2}$ are the magnitudes of the change in magnetic field in the x-direction and y-direction, as determined using the second magnetometer. The direction of the field changes is the direction of the vectors $[B_{x1}, B_{y1}], [B_{x2}, B_{y2}]$. Disregarding the magnitude of the change, the direction can be represented as the cartesian gradient in the ratios $b_1 = B_{x1}/B_{y1}$ and $b_2 = B_{x2}/B_{y2}$, respectively.

A significant change over a short period of time (i.e. a step-change) in the temporal profiles indicates the occurrence of a transient current inhomogeneity (caused by the transient high-conductivity path 130).

The location of the first magnetometer 200 (the first location) can be considered as (0, 0, 0). Multiple magnetometers may be provided in order to obtain a magnetic field measurement in more than one direction, in this case the first location is the centre of those magnetometers. When the first and second magnetometers are within an x-plane, the location of the second magnetometer 201 (the second location 203) is $(x_s, 0, 0)$. Any non-zero $x_s$ is suitable to allow determination of a transient current inhomogeneity's location, however a larger $x_s$ will provide better accuracy. Ideally, the first and second magnetometers are positioned centrally on the cell with a spacing between them that corresponds to about half the cell's longest dimension.

As at any state of charge a finite voltage is present between any pair of adjacent electrode layers, the transient current inhomogeneity will give rise to a (positive or negative) current along the path $(x_d, y_d, (z_d -L/2))$ to $(x_d, y_d, (z_d +L/2))$. This current leads to a field change in the x-y plane at both magnetometer locations. The position $(x_d, y_d)$ is determined from the measured field change values through equation 1 and equation 2 respectively.

$$ x_d = x_s \left( \frac{b_2}{b_2 - b_1} \right) \text{ Equation 1} $$

$$ y_d = x_s \left( \frac{b_1 b_2}{b_1 - b_2} \right) \text{ Equation 2} $$

The current I in the path can be calculated from the magnitude of the magnetic field change at either sensor. For simplicity we use the first magnetometer at (0, 0, 0) which means that the distance r is given by:

$$ r^2 = x_d{}^2 + y_d{}^2 $$

and assuming the $z_d = 0$ and therefore $B_{z1} = 0$, the magnetic field magnitude at the first magnetometer is:

$$ B_1{}^2 = B_{x1}{}^2 + B_{y1}{}^2 $$

So, the current according to Biot-Savart is:

$$ I = (B_1 r^2/L)(4\pi/\mu_0) $$

A geometric determination of the location $(x_d, y_d)$ of the transient current inhomogeneity can be done as follows, and is illustrated in figure 5. The magnetic field produced by the transient current inhomogeneity 120 is illustrated by contour lines 300. A two-dimensional vector change (in the x-y plane) in the magnetic field at the first location 202 resulting from the transient current inhomogeneity 120 is calculated. An imaginary straight line 320 is constructed passing through the first location 202 along a direction orthogonal to the vector change 310 in magnetic field. The same is repeated at the second location 203. The location $(x_d, y_d)$ of the transient current inhomogeneity is given by the crossing point of the two imaginary lines 320.

The principle applies for calculation of a three-dimensional coordinate for the transient current inhomogeneity (i.e. including the z coordinate), by including measurements of the change in electric field as measured by a magnetometer at a third location adjacent the electrochemical cell. For example, the cell may comprise a stack of electrodes and the method may determine between which electrodes the transient current inhomogeneity occurred. By measuring the change in magnetic field in three dimensions at each magnetometer location, the position of the defect $(x_d, y_d, z_d)$ in three dimensions can be determined via the interception point of imaginary lines normal in three dimensions.

By providing additional magnetometers to measure the magnetic field at further locations adjacent to the electrochemical cell, the accuracy and precision of the method can be increased.

A certainty value associated with the attribution of the magnetic field change to a transient current inhomogeneity caused by a point-like transient high-conductivity path can be calculated as follows. A field ratio (the ratio of the magnitude of the vector change at the first and second locations) is calculated. A distance ratio (the ratio of the distances between the defect location $(x_d, y_d)$ and respective first and second locations) is calculated. The field ratio and the distance ratio will be reciprocal to each other when the field change is indeed caused by a single point-like transient current inhomogeneity. Therefore, the closer the product of the two ratios is to one, the higher the certainty that the field change is indeed caused by the occurrence of a single, point-like soft sort event. A substantial deviation from one, would indicate a more complex situation, arising for example from multiple simultaneous defects or a defect of extended size in the x-y-direction such that it cannot be considered point-like.

The magnitude of the three-dimensional change in magnetic field measured at any one location adjacent the electrochemical cell is directly proportional to the current of the transient current inhomogeneity. The magnitude of the three-dimensional change in magnetic field, and the distance of the location of that change from the transient current inhomogeneity enables the current to be determined. Integrating this current over the time of the transient current inhomogeneity provides a determination of the charge transferred by the transient current inhomogeneity.

The absolute field magnitude is also directly proportional to the conductivity of the transient high-conductivity path 130.

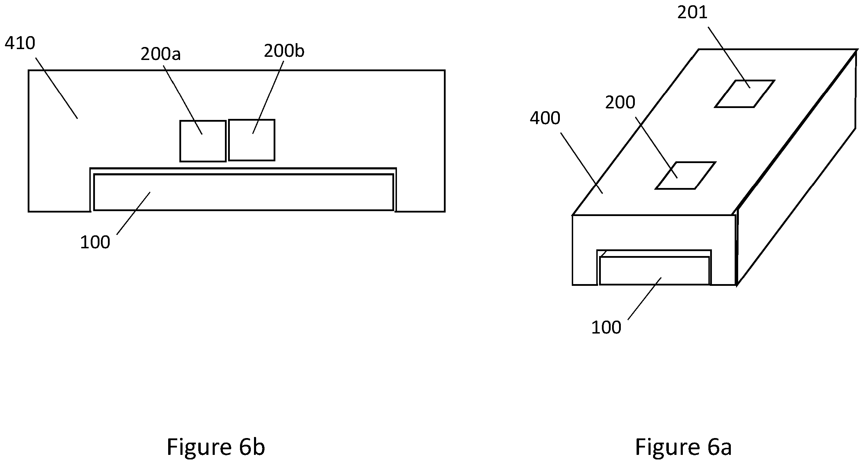

Figure 6a shows a structure 400 in which the first magnetometer 200 and the second magnetometer 201 are mounted. The electrochemical cell 100 is positioned within the structure so that the locations and orientations of the magnetometers are predetermined.

Figure 6b shows a structure 410 in which two magnetometers 200a and 200b are positioned at the first location. One magnetometer 200a may measure the magnetic field in a first direction and the other magnetometer 200b may measure the magnetic field in a second, non-parallel direction.

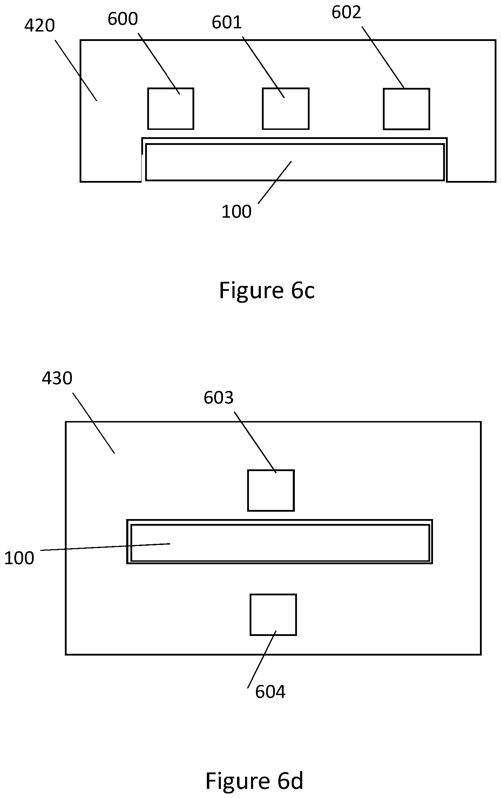

Figure 6c shows a structure 420 in which three magnetometers 600, 601, 602 are mounted. The magnetometers measure the magnetic field in a first, second and third location respectively.

Figure 6d shows a structure 430 in which the electrochemical cell is positioned such that magnetometers 603 and 604 are positioned above and below the electrochemical cell.

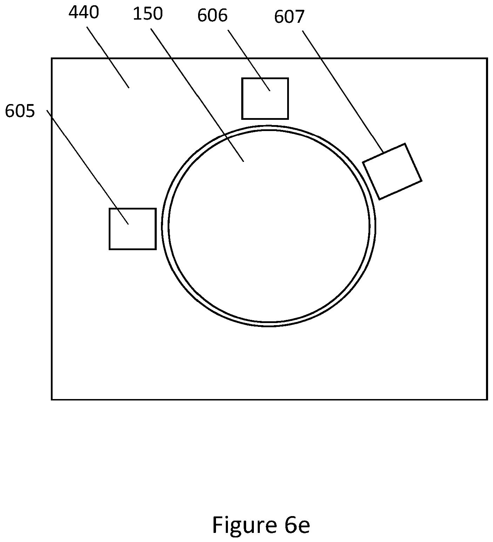

Figure 6e shows a structure 440 in which a cylindrical electrochemical cell 150 can be positioned. Magnetometers 605, 606, and 607 are mounted in the structure 440 such that the direction in which the magnetic field is measured remains parallel to the anode and cathode layers within the electrochemical cell 150.

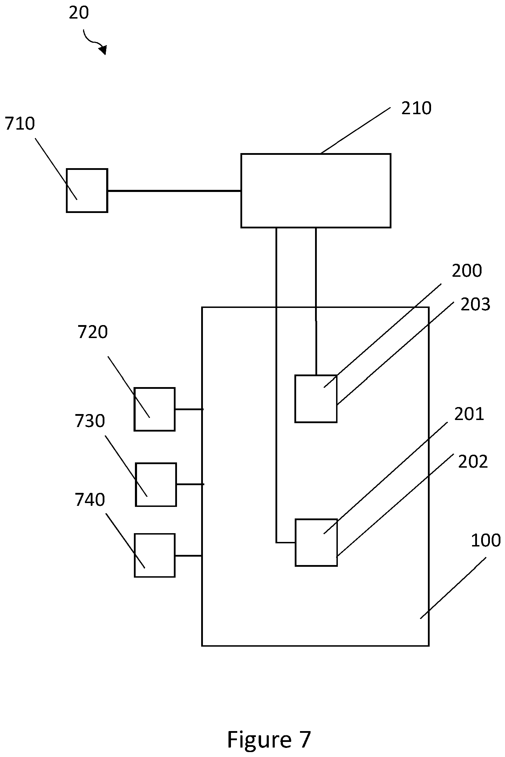

Figure 7 shows a system 20 for non-invasive characterisation of an electrochemical cell. The system 20 comprises magnetometers 200, 201 and the controlling and processing subsystem 210 as in system 10, and additionally includes a background magnetometer 710, a heating system 720, a conditioning unit 730, and a charge cycling unit 740.

The following clauses set out features of the invention which may or may not presently be claimed in this application but which may form basis for future amendment or a divisional application.

1. A method of characterising a condition of an electrochemical cell comprising a plurality of electrodes, the method comprising:

    positioning one or more magnetometers adjacent to an electrode surface of the electrochemical cell to measure magnetic field of the electrochemical cell at a first location;
    measuring the magnetic field generated by the electrochemical cell for a predetermined length of time, the measuring providing a first temporal profile of the magnetic field in an x-direction and a second temporal profile of the magnetic field in a y-direction, at the first location;
    confirming occurrence of a transient current inhomogeneity within the electrochemical cell based on identifying a step-change in an x-component of the magnetic field from the first temporal profile and a coincident step-change in a y-component of the magnetic field from the second temporal profile; and
    determining a characteristic of the electrochemical cell based on the occurrence of transient current inhomogeneities.

2. A method of characterising a condition of an electrochemical cell comprising a plurality of electrodes, the method comprising:

    positioning a magnetometer adjacent to an electrode surface of the electrochemical cell to measure magnetic field of the electrochemical cell at a first location;

measuring the magnetic field generated by the electrochemical cell for a predetermined length of time, the measuring providing a first temporal profile of the magnetic field at the first location; confirming occurrence of a transient current inhomogeneity within the electrochemical cell based on identifying a discontinuity in the temporal profile, wherein the discontinuity comprises a region within the temporal profile defined between a first step change, and a second step-change, wherein the second step-change is in an opposite direction to the first step-change; and

determining a characteristic of the electrochemical cell based on the occurrence of transient current inhomogeneities.

3. The method as recited in clause 1 or 2, comprising:

positioning, at a second location, one or more magnetometers adjacent to the electrode surface of the electrochemical cell to measure magnetic field of the electrochemical cell at the second location;

measuring the magnetic field generated by the electrochemical cell at the second location for the predetermined length of time while the electrochemical cell is in the passive state, the measuring providing a temporal profile of an x-component of the magnetic field and/or a temporal profile of a y-component of the magnetic field at the second location; and

using the temporal profile(s) of the x- and/or y-components to:

determine a vector change in magnetic field corresponding to the transient current inhomogeneity at the first location; determine a vector change in magnetic field corresponding to the transient current inhomogeneity at the second location; and determine a location of the transient current inhomogeneity using the Biot-Savart law, or a geometric determination whereby an intersection point of an imaginary line extending from each of the first and second locations in a direction orthogonal to the change in the magnetic field at the first and second locations provides the location of the transient current inhomogeneity.

4. A method of characterising a condition within an electrochemical cell comprising a plurality of electrodes, the method comprising:

positioning a magnetometer adjacent to an electrode surface of the electrochemical cell to measure magnetic field of the electrochemical cell at a first location;

positioning a magnetometer adjacent to an electrode surface of the electrochemical cell to measure magnetic field of the electrochemical cell at a second location;

measuring the magnetic field generated by the electrochemical cell for a predetermined length of time, the measuring providing a first temporal profile of a directional component of the magnetic field at the first location, and a second temporal profile of a directional component of the magnetic field at the second location;

confirming occurrence of a transient current inhomogeneity within the electrochemical cell based on identifying a step-change in the first temporal profile and a coincident step-change in the second temporal profile; and

determining a characteristic of the electrochemical cell based on the occurrence of transient current inhomogeneities.

5. The method as recited in clause 4, comprising:

determining a vector change in magnetic field corresponding to the transient current inhomogeneity at the first location;

determining a vector change in magnetic field corresponding to the transient current inhomogeneity at the second location; and

determining a location of the transient current inhomogeneity using the Biot-Savart law, or a geometric determination whereby an intersection point of an imaginary line extending from each of the first and second locations in a direction orthogonal to the change in the magnetic field at the first and second locations provides the location of the transient current inhomogeneity.

6. The method as recited in any of clauses 3, 4 or 5, comprising

positioning one or more magnetometers adjacent to the electrochemical cell to measure magnetic field of the electrochemical cell at a third location;

measuring the magnetic field generated by the electrochemical cell at the third location for the predetermined length of time while the electrochemical cell is in the passive state, the measuring providing a temporal profile of the x-component of the magnetic field and/or the y-component of the magnetic field at the third location; determining a vector change in the magnetic field corresponding to the transient current inhomogeneity, as measured at the first, second and third locations, and

determining a three-dimensional location of the transient current inhomogeneity based on the vector changes at the first, second and third locations.

7. The method as recited in any preceding clause, wherein the step changes have a magnitude of more than 3 pT, and occur over a time period of less than 500 seconds.

8. The method as recited in any of clauses 3 to 7, comprising:

determining a vector change in the magnetic field at the first location over a duration of the transient current inhomogeneity;

determining a charge transferred by the transient current inhomogeneity based on the magnitude of the vector change in magnetic field, a perpendicular distance between an anode layer and an adjacent cathode layer within the electrochemical cell, and a distance between the first location and the location of the transient current inhomogeneity.

9. The method as recited in clause 8, wherein the characteristic of the electrochemical cell is one or more of: charge transferred per transient current inhomogeneity, charge transferred by transient current inhomogeneities per time per area or volume.

10. The method as recited in any of clauses 3 to 9, comprising:

determining a vector change in magnetic field corresponding to the transient current inhomogeneity at each magnetometer location;

determining a field ratio as the ratio of the magnitude of the vector change in magnetic field strength at the first location and the magnitude of the vector change in magnetic field strength at the second location;

determining a distance ratio as the ratio of a distance between the first location and the location of the transient current inhomogeneity and a distance between the second location and the location of a transient current inhomogeneity, comparing the field ratio and distance ratio; and if the product of the field ratio and the distance ratio is between 0.9 and 1.1, attributing, with a 95% confidence interval, the transient current inhomogeneity to a single point-like transient defect within the electrochemical cell.

11. The method as recited in any of clauses 3 to 10, comprising:

identifying a plurality of step-changes within the temporal profiles to identify one or more discontinuities, each between a first step-change and a second step-change in an opposite direction to the first step-change, each of the discontinuities occurring at a respective coincident time across the temporal profiles;

determining a spatial and temporal distribution of transient current inhomogeneities based on measurements obtained by the magnetometers relating to each discontinuity.

12. The method as recited in clause 11, wherein the plurality of discontinuities have overlapping regions, and the method comprises:

determining a spatial and temporal distribution of transient current inhomogeneities based on measurements obtained by the magnetometers relating to each discontinuity.

13. The method as recited in any preceding clause, wherein the electrochemical cell is in a passive state while measuring the magnetic field generated by the electrochemical cell for the predetermined length of time.

14. The method as recited in any preceding clause, wherein a charge and/or discharge of the cell is induced prior to measuring the magnetic field generated by the electrochemical cell for the predetermined length of time.

15. The method as recited in any preceding clause, wherein a background magnetic field is excluded from the temporal profiles.

16. The method as recited in any preceding clause, comprising identifying two or more transient current inhomogeneities within the temporal profiles, wherein the characteristic is a number of transient current inhomogeneities per time per electrochemical cell area or volume, or the mean time between the beginning of transient current inhomogeneities per cell area or volume.

17. The method as recited in any preceding clause, wherein confirming occurrence of a transient current inhomogeneity comprises identifying a discontinuity in a temporal profile, wherein the discontinuity comprises a region within the temporal profile defined between a first step-change and a second step-change, wherein the second step-change is in an opposite direction to the first step-change.

18. The method as recited in clause 17, wherein the region has a duration of greater than one hour.

19. The method as recited in clause 17 or 18, wherein the characteristic is a duration of transient current inhomogeneity, or a duration of transient current inhomogeneities per time.

20. The method as recited in any previous clause, comprising providing a rating of an electrochemical cell based on a characteristic, or a combination of, characteristics.

21. The method as recited in any preceding clause, wherein the characteristic is a magnitude of a vector change in magnetic field during a transient current inhomogeneity, or a rate of change in the magnitude of a vector change in magnetic field during a transient current inhomogeneity.

22. The method as recited in any preceding clause, wherein the predetermined length of time for measuring the changes in the magnetic field is greater than 12 hours.

23. The method as recited in any preceding clause, wherein the electrochemical cell is one of a pouch cell, prismatic cell and a cylindrical cell.

24. The method as recited in any preceding clause, wherein the electrochemical cell comprises lithium.

25. The method as recited in any preceding clause, wherein the one or more magnetometers are quantum magnetometers (optionally one of optically pumped quantum magnetometers (OPMs) and super conducting quantum interference device (SQUIDS)).

26. The method as recited in any preceding clause, wherein the electrochemical cell is heated to a predetermined temperature while the magnetometers measure the magnetic field generated by the electrochemical cell, and/or the electrochemical cell is charged to a predetermined state of charge while the magnetometers measure the magnetic field generated by the electrochemical cell, and/or the electrochemical cell is conditioned to a have predetermined state of health while the magnetometers measure the magnetic field generated by the electrochemical cell.

27. The method as recited in any preceding clause, wherein the electrochemical cell is a planar electrochemical cell and magnetometers are positioned at four locations in a row across the electrochemical cell, with two magnetometers positioned over locations of the electrode surface, and two magnetometers positioned to locations at opposite, side edges of the electrochemical cell.

28. The method as recited in any preceding clause, wherein the plurality of electrodes comprises a stack of interleaved anode layers and cathode layers, optionally, adjacent anode and cathode layers are spaced by a distance of less than 25 $\mu$m.

29. A system for non-invasive characterisation of an electrochemical cell comprising: one or more magnetometers configured to be disposed adjacent to the electrochemical cell at a first location, each of the one or more magnetometers having a sensitivity capable of measuring magnetic fields caused by internal currents of the cell in the passive state and the one or more magnetometers configured to provide a measure of magnetic field in an x-direction and a y-direction at the first location for a predetermined length of time; and
a controlling and processing subsystem, wherein the controlling and processing subsystem is configured to:

take measurements with the one or more magnetometers, for the predetermined length of time, of a magnetic field at the first location;
provide a first temporal profile of the magnetic field at the first location in the x-direction and a second temporal of the magnetic field at the first location in the y-direction;
confirm occurrence of a transient current inhomogeneity within the electrochemical cell based on identifying a coincident step-change in the x-component and y-component of the magnetic field from each temporal profile; and
determine a characteristic of the electrochemical cell based on the occurrence of transient current inhomogeneities.

30. A system for non-invasive characterisation of an electrochemical cell comprising:

a magnetometer configured to be disposed adjacent to the electrochemical cell at a first location, the magnetometer having a sensitivity capable of measuring magnetic fields caused by internal currents of the cell in the passive state and configured to provide a measure of magnetic field over a predetermined length of time; and
a controlling and processing subsystem, wherein the controlling and processing subsystem is configured to:

take measurements with the magnetometer for the predetermined length of time;
provide a temporal profile of a directional component of the magnetic field local to the magnetometer;
confirm occurrence of a transient current inhomogeneity within the electrochemical cell based on identifying a discontinuity in the temporal profile, wherein the discontinuity comprises a region within the temporal profile defined between a first step-change, and a second step-change; and
determine a characteristic of the electrochemical cell based on the occurrence of transient current inhomogeneities.

31. The system as recited in any of clauses 28 or 29, comprising one or more magnetometers configured to be disposed adjacent to the electrochemical cell at a second location, each of the one or more magnetometers having a sensitivity capable of measuring magnetic fields caused by internal currents of the cell in the passive state and the one or more magnetometers configured to provide a measure of magnetic field in an x-direction and a y-direction at the second location for the predetermined length of time, and wherein the controlling and processing subsystem is configured to perform one or more of:

i) determine a vector change in magnetic field corresponding to the transient current inhomogeneity at the first location;

determine a vector change in magnetic field corresponding to the transient current inhomogeneity at the second location; and determine a location of the transient current inhomogeneity using a geometric determination whereby an intersection point of an imaginary line extending from each of the first and second locations in a direction orthogonal to the change in the magnetic field at the first and second locations provides the location of the transient current inhomogeneity;

ii) determine a vector change in magnetic field corresponding to the transient current inhomogeneity at each magnetometer location;

determine a field ratio as the ratio of the magnitude of the vector change in magnetic field strength at the first location and the magnitude of the vector change in magnetic field strength at the second location; determine a distance ratio as the ratio of a distance between the first location and the location of the transient current inhomogeneity and a distance between the second location and the location of a transient current inhomogeneity, compare the field ratio and distance ratio; and if the product of the field ratio and the distance ratio is between 0.9 and 1.1, attribute, with a 95% confidence interval, the transient current inhomogeneity to a single point-like transient defect within the electrochemical cell;

iii) identify a plurality of step-changes within the temporal profiles to identify one or more discontinuities, each between a first step-change and a second step-change in an opposite direction to the first step-change, each of the discontinuities occurring at a respective coincident time across the temporal profiles; determine a spatial and temporal distribution of transient current inhomogeneities based on measurements obtained by the magnetometers relating to each discontinuity, and if the plurality of discontinuities have overlapping regions, determine a spatial and temporal distribution of transient current inhomogeneities based on measurements obtained by the magnetometers relating to each discontinuity.
iv) identify two or more transient current inhomogeneities within the temporal profiles, wherein the characteristic is a number of transient current inhomogeneities per time per electrochemical cell area or volume, or the mean time between the beginning of transient current inhomogeneities per cell area or volume;
v) provide a rating of an electrochemical cell based on a characteristic, or a combination of characteristics.

32. The system as recited in any of clauses 29 to 31, wherein the controlling and processing subsystem is configured to perform one or more of:

i) confirm the transient current inhomogeneity by identifying a discontinuity in a temporal profile, wherein the discontinuity comprises a region within the temporal profile defined between a first step-change and a second step-change, wherein the second step-change is in an opposite direction to the first step-change, and determine the characteristic as a duration of transient current inhomogeneity, or a duration of transient current inhomogeneities per time;
ii) confirm occurrence of a transient current inhomogeneity by identifying a discontinuity within a temporal profile, the discontinuity comprising a region within the temporal profile defined between a first step-change and a second step-change, wherein the second step-change is in an opposite direction to the first step-change; and a length of time of the region is greater than one hour;
iii) confirm occurrence of a transient current inhomogeneity by identifying a discontinuity within a temporal profile, the discontinuity comprising a region within the temporal profile defined between a first step-change and a second step-change, wherein the second step-change is in an opposite direction to the first step-change;

determine a vector change in the magnetic field at the first location over a duration of the discontinuity; determine a charge transferred by the transient current inhomogeneity based on the magnitude of the vector change in magnetic field, a perpendicular distance between an anode layer and an adjacent cathode layer within the electrochemical cell, and a distance between the first location and the location of the transient current inhomogeneity, and wherein the characteristic of the electrochemical cell is one or more of: charge transferred per transient current inhomogeneity, charge transferred by transient current inhomogeneities per time per area or volume.

33. A system for non-invasive characterisation of an electrochemical cell comprising:

a plurality of magnetometers, wherein the magnetometers are configured to be disposed adjacent to the cell and have a sensitivity such that they are capable of measuring magnetic fields caused by internal currents of the cell in the passive state and configured to provide a measure of magnetic field for a predetermined length of time; and
a controlling and processing subsystem, wherein the controlling and processing subsystem is configured to:

take measurements with each respective magnetometer of a magnetic field local to each magnetometer;
provide temporal profiles of a directional component of the magnetic field local to each magnetometer;
confirm occurrence of a transient current inhomogeneity within the electrochemical cell based on identifying a coincident step-change in each temporal profile; and
determine a characteristic of the electrochemical cell based on the occurrence of transient current inhomogeneities.

34. The system as recited in clause 33, wherein the plurality of magnetometers comprise one or more magnetometers configured to be disposed adjacent to the electrochemical cell at a first location and one or more magnetometers configured to be disposed adjacent to the electrochemical cell at a second location, such that at each of the first and second locations the one or more magnetometers are capable of providing a measure of magnetic field in an x-direction and a y-direction for a predetermined length of time, and wherein the controlling and processing subsystem is configured to perform one or more of:

i) determine a vector change in magnetic field corresponding to the transient current inhomogeneity at the first location;

determine a vector change in magnetic field corresponding to the transient current inhomogeneity at the second location; and
determine a location of the transient current inhomogeneity using a geometric determination whereby an intersection point of an imaginary line extending from each of the first and second locations in a direction orthogonal to the change in the magnetic field at the first and second locations provides the location of the transient current inhomogeneity;

ii) determine a vector change in magnetic field corresponding to the transient current inhomogeneity at each magnetometer location;

determine a field ratio as the ratio of the magnitude of the vector change in magnetic field strength at the first location and the magnitude of the vector change in magnetic field strength at the second location;
determine a distance ratio as the ratio of a distance between the first location and the location of the transient current inhomogeneity and a distance between the second location and the location of a transient current inhomogeneity,
compare the field ratio and distance ratio; and
if the product of the field ratio and the distance ratio is between 0.9 and 1.1, attribute, with a 95% confidence interval, the transient current inhomogeneity to a single point-like transient defect within the electrochemical cell;

iii) identify a plurality of step-changes within the temporal profiles to identify one or more discontinuities, each between a first step-change and a second step-change in an opposite direction to the first step-change, each of the discontinuities occurring at a respective coincident time across the temporal profiles;
determine a spatial and temporal distribution of transient current inhomogeneities based on measurements obtained by the magnetometers relating to each discontinuity, and
if the plurality of discontinuities have overlapping regions, determine a spatial and temporal distribution of transient current inhomogeneities based on measurements obtained by the magnetometers relating to each discontinuity.
iv) identify two or more transient current inhomogeneities within the temporal profiles, wherein the characteristic is a number of transient current inhomogeneities per time per electrochemical cell area or volume, or the mean time between the beginning of transient current inhomogeneities per cell area or volume;
v) provide a rating of an electrochemical cell based on a characteristic, or a combination of characteristics.

35. The system as recited in any of clauses 33 to 34, wherein the controlling and processing subsystem is configured to perform one or more of:

> i) confirm the transient current inhomogeneity by identifying a discontinuity in a temporal profile, wherein the discontinuity comprises a region within the temporal profile defined between a first step-change and a second step-change, wherein the second step-change is in an opposite direction to the first step-change, and determine the characteristic as a duration of transient current inhomogeneity, or a duration of transient current inhomogeneities per time;
> ii) confirm occurrence of a transient current inhomogeneity by identifying a discontinuity within a temporal profile, the discontinuity comprising a region within the temporal profile defined between a first step-change and a second step-change, wherein the second step-change is in an opposite direction to the first step-change; and a length of time of the region is greater than one hour;
> iii) confirm occurrence of a transient current inhomogeneity by identifying a discontinuity within a temporal profile, the discontinuity comprising a region within the temporal profile defined between a first step-change and a second step-change, wherein the second step-change is in an opposite direction to the first step-change;

>> determine a vector change in the magnetic field at the first location over a duration of the discontinuity;
>> determine a charge transferred by the transient current inhomogeneity based on the magnitude of the vector change in magnetic field, a perpendicular distance between an anode layer and an adjacent cathode layer within the electrochemical cell, and a distance between the first location and the location of the transient current inhomogeneity, and wherein the characteristic of the electrochemical cell is one or more of: charge transferred per transient current inhomogeneity, charge transferred by transient current inhomogeneities per time per area or volume.

36. The system as recited in any of clauses 29 to 35, wherein the controlling and processing subsystem is configured to take measurements with each respective magnetometer for the predetermined length of time while the cell is in a passive state.

37. The system as recited in any of clauses 29 to 36, wherein the predetermined length of time for measuring the changes in the magnetic field is greater than 12 hours.

38. The system as recited in any of clauses 29 to 37, wherein the electrochemical cell is one of a pouch cell, prismatic cell and a cylindrical cell, and/or the electrochemical cell comprises lithium.

39. The system as recited in any of clauses 29 to 38, wherein the magnetometers are quantum-based magnetometers.

40. The system as recited in any of clauses 29 to 39 comprising a magnetic shield for shielding an environment, for containing the electrochemical cell and magnetometers, from background magnetic field noise.

41. The system as recited in any of clauses 29 to 40, comprising a background magnetometer configured to be disposed distally from the electrochemical cell.

42. The system as recited in any of clauses 29 to 41, comprising a heating system configured to maintain the electrochemical cell at a predetermined temperature during measurement of the magnetic field for the predetermined length of time.

43. The system as recited in any of clauses 29 to 42, comprising a charge cycling unit configured to be connected to the electrochemical cell for placing the electrochemical cell in a predetermined state of charge prior to the measuring of the magnetic field generated by the electrochemical cell.

44. The system as recited in any of clauses 29 to 43, comprising a conditioning unit configured to be connected to the electrochemical cell to place the electrochemical cell in a predetermined state of health.

## Claims

1. A method of characterising a condition of an electrochemical cell comprising a plurality of electrodes, the method comprising:

> positioning one or more magnetometers adjacent to an electrode surface of the electrochemical cell to measure magnetic field of the electrochemical cell at a first location;
> measuring the magnetic field generated by the electrochemical cell for a predetermined length of time, the measuring providing a first temporal profile of the magnetic field in an x-direction and a second temporal profile of the magnetic field in a y-direction, at the first location;
> confirming occurrence of a transient current inhomogeneity within the electrochemical cell based on identifying a step-change in an x-component of the magnetic field from the first temporal profile and a coincident step-change in a y-component of the magnetic field from the second temporal profile; and
> determining a characteristic of the electrochemical cell based on the occurrence of transient current inhomogeneities.

2. A method of characterising a condition of an electrochemical cell comprising a plurality of electrodes, the method comprising:

    positioning a magnetometer adjacent to an electrode surface of the electrochemical cell to measure magnetic field of the electrochemical cell at a first location;
    measuring the magnetic field generated by the electrochemical cell for a predetermined length of time, the measuring providing a first temporal profile of the magnetic field at the first location;
    confirming occurrence of a transient current inhomogeneity within the electrochemical cell based on identifying a discontinuity in the temporal profile, wherein the discontinuity comprises a region within the temporal profile defined between a first step change, and a second step-change, wherein the second step-change is in an opposite direction to the first step-change; and
    determining a characteristic of the electrochemical cell based on the occurrence of transient current inhomogeneities.

3. The method as claimed in claim 1 or 2, comprising:

    positioning, at a second location, one or more magnetometers adjacent to the electrode surface of the electrochemical cell to measure magnetic field of the electrochemical cell at the second location;
    measuring the magnetic field generated by the electrochemical cell at the second location for the predetermined length of time while the electrochemical cell is in the passive state, the measuring providing a temporal profile of an x-component of the magnetic field and/or a temporal profile of a y-component of the magnetic field at the second location; and
    using the temporal profile(s) of the x- and/or y-components to:

        determine a vector change in magnetic field corresponding to the transient current inhomogeneity at the first location;
        determine a vector change in magnetic field corresponding to the transient current inhomogeneity at the second location; and
        determine a location of the transient current inhomogeneity using the Biot-Savart law, or a geometric determination whereby an intersection point of an imaginary line extending from each of the first and second locations in a direction orthogonal to the change in the magnetic field at the first and second locations provides the location of the transient current inhomogeneity.

4. A method of characterising a condition within an electrochemical cell comprising a plurality of electrodes, the method comprising:

    positioning a magnetometer adjacent to an electrode surface of the electrochemical cell to measure magnetic field of the electrochemical cell at a first location;
    positioning a magnetometer adjacent to an electrode surface of the electrochemical cell to measure magnetic field of the electrochemical cell at a second location;
    measuring the magnetic field generated by the electrochemical cell for a predetermined length of time, the measuring providing a first temporal profile of a directional component of the magnetic field at the first location, and a second temporal profile of a directional component of the magnetic field at the second location;
    confirming occurrence of a transient current inhomogeneity within the electrochemical cell based on identifying a step-change in the first temporal profile and a coincident step-change in the second temporal profile; and
    determining a characteristic of the electrochemical cell based on the occurrence of transient current inhomogeneities,
    optionally wherein the method comprises:

        determining a vector change in magnetic field corresponding to the transient current inhomogeneity at the first location;
        determining a vector change in magnetic field corresponding to the transient current inhomogeneity at the second location; and
        determining a location of the transient current inhomogeneity using the Biot-Savart law, or a geometric determination whereby an intersection point of an imaginary line extending from each of the first and second locations in a direction orthogonal to the change in the magnetic field at the first and second locations provides the location of the transient current inhomogeneity.

5. The method as claimed in claim 4, comprising:

    positioning one or more magnetometers adjacent to the electrochemical cell to measure magnetic field of the electrochemical cell at a third location;
    measuring the magnetic field generated by the electrochemical cell at the third location for the predetermined length of time while the electrochemical cell is in the passive state, the measuring providing a temporal profile of the x-component of the magnetic field and/or the y-component of the magnetic field at the third location;

determining a vector change in the magnetic field corresponding to the transient current inhomogeneity, as measured at the first, second and third locations, and
determining a three-dimensional location of the transient current inhomogeneity based on the vector changes at the first, second and third locations, and/or, the method comprising:

determining a vector change in the magnetic field at the first location over a duration of the transient current inhomogeneity; and
determining a charge transferred by the transient current inhomogeneity based on the magnitude of the vector change in magnetic field, a perpendicular distance between an anode layer and an adjacent cathode layer within the electrochemical cell, and a distance between the first location and the location of the transient current inhomogeneity, wherein
the characteristic is one or more of: charge transferred per transient current inhomogeneity, charge transferred by transient current inhomogeneities per time per area or volume.

6. The method as claimed in any preceding claim, wherein the electrochemical cell is in a passive state while measuring the magnetic field generated by the electrochemical cell for the predetermined length of time, and/or wherein a background magnetic field is excluded from the temporal profiles

7. The method as claimed in any preceding claim, wherein the step changes have a magnitude of more than 3 pT, and occur over a time period of less than 500 seconds, and/or
the method comprising providing a rating of an electrochemical cell based on a characteristic, or a combination of, characteristics.

8. The method as claimed in any preceding claim, comprising identifying two or more transient current inhomogeneities within the temporal profiles, wherein the characteristic is a number of transient current inhomogeneities per time per electrochemical cell area or volume, or the mean time between the beginning of transient current inhomogeneities per cell area or volume.

9. The method as claimed in any preceding claim, wherein the one or more magnetometers are quantum magnetometers (optionally one of optically pumped quantum magnetometers (OPMs) and super conducting quantum interference device (SQUIDS)).

10. The method as claimed in any preceding claim, wherein the electrochemical cell is heated to a predetermined temperature while the magnetometers measure the magnetic field generated by the electrochemical cell, and/or
the electrochemical cell is charged to a predetermined state of charge while the magnetometers measure the magnetic field generated by the electrochemical cell, and/or the electrochemical cell is conditioned to a have predetermined state of health while the magnetometers measure the magnetic field generated by the electrochemical cell.

11. A system for non-invasive characterisation of an electrochemical cell comprising: one or more magnetometers configured to be disposed adjacent to the electrochemical cell at a first location, each of the one or more magnetometers having a sensitivity capable of measuring magnetic fields caused by internal currents of the cell in the passive state and the one or more magnetometers configured to provide a measure of magnetic field in an x-direction and a y-direction at the first location for a predetermined length of time; and
a controlling and processing subsystem, wherein the controlling and processing subsystem is configured to:

take measurements with the one or more magnetometers, for the predetermined length of time, of a magnetic field at the first location;
provide a first temporal profile of the magnetic field at the first location in the x-direction and a second temporal of the magnetic field at the first location in the y-direction;
confirm occurrence of a transient current inhomogeneity within the electrochemical cell based on identifying a coincident step-change in the x-component and y-component of the magnetic field from each temporal profile; and
determine a characteristic of the electrochemical cell based on the occurrence of transient current inhomogeneities.

12. A system for non-invasive characterisation of an electrochemical cell comprising:

a magnetometer configured to be disposed adjacent to the electrochemical cell at a first location, the magnetometer having a sensitivity capable of measuring magnetic fields caused by internal currents of the cell in the passive state and configured to provide a measure of magnetic field over a predetermined length of time; and
a controlling and processing subsystem, wherein the controlling and processing subsystem is configured to:

take measurements with the magnetometer for the predetermined length of time;
provide a temporal profile of a directional component of the magnetic field local to the magnetometer;
confirm occurrence of a transient current inhomogeneity within the electrochemical cell based on identifying a discontinuity in the temporal profile, wherein the discontinuity comprises a region within the temporal profile defined between a first step-change and a second step-change; and
determine a characteristic of the electrochemical cell based on the occurrence of transient current inhomogeneities.

13. A system for non-invasive characterisation of an electrochemical cell comprising:

a plurality of magnetometers, wherein the magnetometers are configured to be disposed adjacent to the cell and have a sensitivity such that they are capable of measuring magnetic fields caused by internal currents of the cell in the passive state and configured to provide a measure of magnetic field for a predetermined length of time; and
a controlling and processing subsystem, wherein the controlling and processing subsystem is configured to:

take measurements with each respective magnetometer of a magnetic field local to each magnetometer;
provide temporal profiles of a directional component of the magnetic field local to each magnetometer;
confirm occurrence of a transient current inhomogeneity within the electrochemical cell based on identifying a coincident step-change in each temporal profile; and
determine a characteristic of the electrochemical cell based on the occurrence of transient current inhomogeneities.

14. The system as claimed in any of claims 11 to 13 comprising a magnetic shield for shielding an environment, for containing the electrochemical cell and magnetometers, from background magnetic field noise.

15. The system as claimed in any of claims 11 to 14, comprising a heating system configured to maintain the electrochemical cell at a predetermined temperature during measurement of the magnetic field for the predetermined length of time, and/or
the system comprises a charge cycling unit configured to be connected to the electrochemical cell for placing the electrochemical cell in a predetermined state of charge prior to the measuring of the magnetic field generated by the electrochemical cell.

Figure 1

Figure 2

FIG. 3a

FIG. 3b

EP 4 749 305 A1

Figure 3c

Figure 3d

Figure 4

EP 4 749 305 A1

Figure 5

201

200

400

100

Figure 6a

200b

200a

100

410

Figure 6b

420    600         601              602

100

Figure 6c

430         603

100

604

Figure 6d

440　　150　　606　　607

605

Figure 6e

EP 4 749 305 A1

Figure 7

EUROPEAN SEARCH REPORT

**Application Number**

EP 24 21 5596

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/357402 A1 (KENDALL GARY [GB] ET AL) 10 November 2022 (2022-11-10) * paragraphs [0009] - [0016], [0021] - [0046], [0073] - [0080]; figures 1-3, 5-6 * | 1-15 | INV. G01R31/382 G01R31/392 H01M10/48 G01R33/032 |
| A | EP 2 703 830 A2 (FORSCHUNGSZENTRUM JUELICH GMBH [DE]) 5 March 2014 (2014-03-05) * paragraphs [0055] - [0063], [0127] - [0142]; figures 1-5 * | 1-15 | |
| A | US 2020/365952 A1 (NAGANO SHINTARO [JP]) 19 November 2020 (2020-11-19) * paragraphs [0029] - [0089]; figures 1-6 * | 1-15 | |
| A | MEHRNAZ JAVADIPOUR ET AL: "Analysis of current density in the electrode and electrolyte of lithium-ion cells for ageing estimation applications", IET SMART GRID, JOHN WILEY & SONS, INC, HOBOKEN, USA, vol. 4, no. 2, 11 March 2021 (2021-03-11), pages 176-189, XP006111330, ISSN: 2515-2947, DOI: 10.1049/STG2.12018 * paragraphs [0003] - [0004]; figures 1-5 * | 1-15 | TECHNICAL FIELDS SEARCHED (IPC) G01R H01M |
| A | YINAN HU ET AL: "Battery Diagnostics with Sensitive Magnetometry", ARXIV.ORG, CORNELL UNIVERSITY LIBRARY, 201 OLIN LIBRARY CORNELL UNIVERSITY ITHACA, NY 14853, 29 May 2019 (2019-05-29), XP081365593, * paragraph [Measurementsetup] - paragraph [Effectofmechanicaldamageoninducedmagnetic ...]; figures 1-4 * | 1-15 | |

The present search report has been drawn up for all claims

| Place of search | Date of completion of the search | Examiner |
|---|---|---|
| Munich | 14 May 2025 | Maric, Viktor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P4C01)

## ANNEX TO THE EUROPEAN SEARCH REPORT
## ON EUROPEAN PATENT APPLICATION NO.

EP 24 21 5596

This annex lists the patent family members relating to the patent documents cited in the above-mentioned European search report.
The members are as contained in the European Patent Office EDP file on
The European Patent Office is in no way liable for these particulars which are merely given for the purpose of information.

14-05-2025

| Patent document cited in search report | Publication date | Patent family member(s) | Publication date |
|---|---|---|---|
| US 2022357402 A1 | 10-11-2022 | EP 4026181 A1<br>GB 2586829 A<br>US 2022357402 A1<br>WO 2021044155 A1 | 13-07-2022<br>10-03-2021<br>10-11-2022<br>11-03-2021 |
| EP 2703830 A2 | 05-03-2014 | DE 102012016837 A1<br>EP 2703830 A2 | 27-02-2014<br>05-03-2014 |
| US 2020365952 A1 | 19-11-2020 | CN 111948558 A<br>JP 2020187951 A<br>US 2020365952 A1 | 17-11-2020<br>19-11-2020<br>19-11-2020 |

EPO FORM P0459

For more details about this annex : see Official Journal of the European Patent Office, No. 12/82